# EUROPEAN PATENT SPECIFICATION

(11) **EP 4 293 480 B1**
(45) Date of publication and mention of the grant of the patent: **23.07.2025**
(21) Application number: 21928413.0
(22) Date of filing: 01.03.2021
(51) Int. Cl.: G06F 3/00, G06F 13/40, G06F 13/42, G06F 13/38

(54) **INTERFACE CIRCUIT, ELECTRONIC DEVICE, DATA TRANSMISSION APPARATUS AND DATA TRANSMISSION SYSTEM**
SCHNITTSTELLENSCHALTUNG, ELEKTRONISCHE VORRICHTUNG, DATENÜBERTRAGUNGSVORRICHTUNG UND DATENÜBERTRAGUNGSSYSTEM
CIRCUIT D'INTERFACE, DISPOSITIF ÉLECTRONIQUE, APPAREIL DE TRANSMISSION DE DONNÉES ET SYSTÈME DE TRANSMISSION DE DONNÉES

(43) Date of publication of application: 20.12.2023
(73) Proprietor: Huawei Technologies Co., Ltd., Shenzhen, Guangdong 518129 (CN)
(72) Inventor: QIAN, Zhaohua, Shenzhen, Guangdong 518129 (CN); KE, Jiandong, Shenzhen, Guangdong 518129 (CN); WANG, Jingjing, Shenzhen, Guangdong 518129 (CN); SHEN, Dongdong, Shenzhen, Guangdong 518129 (CN)
(74) Representative: Körber, Martin Hans
(86) International application number: PCT/CN2021/078479
(87) International publication number: WO 2022/183322

(56) References cited:
- CN-A- 101 419 777
- CN-A- 104 656 514
- CN-A- 110 032 908
- CN-U- 207 074 434
- US-A1- 2011 191 814
- US-A1- 2017 147 526
- US-B1- 8 799 537

## Description

### TECHNICAL FIELD

Embodiments of this application relate to the field of circuits, and in particular, to an interface circuit, an electronic device, a data transmission apparatus, and a data transmission system.

### BACKGROUND

With the development of science and technology, various types of electronic devices, such as tablet computers, mobile phones, host devices, set-top boxes, ultra-thin displays, and virtual reality (VR, Virtual Reality) displays, have sprung up. In addition, electronic devices are also developing in a diversified direction including high integration, small size, large screen, and the like. Moreover, different electronic devices usually transmit data based on different types of interface protocols.

In the current technology, to perform data transmission with electronic devices with various interface types, an electronic device is usually provided with a plurality of types of interfaces. For example, a display device transmits data through a high definition multimedia interface (HDMI, High Definition Multimedia Interface), and another display device transmits data through a display port (DP, DisplayPort). To perform data transmission with display devices with various interface types, a host device is usually provided with a plurality of types of interfaces such as an HDMI and a DP. Similarly, to perform data transmission with host devices with different interface types, a display device is also provided with a plurality of types of interfaces. However, a plurality of types of interfaces coexist and greatly occupy the space of an electronic device and a layout area of an interface chip, which is not conducive to implementation of an electronic device with high integration and small size. Therefore, how to implement compatibility of a plurality of types of interfaces in an electronic device while reducing the space occupied by the interfaces in the electronic device needs to be resolved. Document US 8 799537 B1 describes a system and corresponding method for selectively communicating data between a first device and a second device is provided. Document US 2017/147526 A1 describes a service redirect operation mode that allows a tester device to perform software burn-in, firmware upgrade, and other related device interrogation via a USB Type-C connection. Document US2011/191814 A1 describes a passive cable adaptor for connecting a data source device with a display device.

### SUMMARY

To achieve the foregoing objective, the following technical solutions are used in this application.

According to a first aspect, an embodiment of this application provides an interface circuit. The interface circuit performs data transmission with a first device by using a data transmission apparatus. The interface circuit includes an interface indication end and a data transmission end. The interface circuit obtains indication information from an indicator of the data transmission apparatus through the interface indication end. The indication information indicates a data transmission interface protocol of the first device. The interface circuit is configured to transmit data to the first device through the data transmission end based on the data transmission interface protocol of the first device indicated by the indication information.

According to the interface circuit shown in this embodiment of this application, a protocol type of a data transmission interface in the first device is determined based on the indication information obtained from the indicator, and then data transmission is performed with the first device based on an interface protocol of a same type as that of the first device. Therefore, according to the interface circuit provided in this embodiment of this application, one physical interface can be reused to implement a plurality of transmission interface protocols, so that data transmission with electronic devices with different interface types can be implemented. Compared with a conventional electronic device provided with a plurality of types of interfaces, a layout area occupied by the interface in an electronic device is reduced, which is conducive to implementation of an electronic device with high integration and small size.

The interface circuit provided in this embodiment of this application may include a plurality of possible implementations.

Implementation 1: The interface circuit includes a plurality of interface controllers, a multiplexer, a port physical layer, and a mode controller. The plurality of interface controllers are respectively coupled to a plurality of input ends of the multiplexer. An output end of the multiplexer is coupled to a first end of the port physical layer. A second end of the port physical layer is coupled to the data transmission end of the interface circuit. An input end of the mode controller is coupled to the interface indication end of the interface circuit, an output end of the mode controller is coupled to a first control end of the multiplexer, and the mode controller controls, based on the indication information, the multiplexer to connect a first interface controller in the plurality of interface controllers to the port physical layer.

Further, the output end of the mode controller is further coupled to a second control end of the port physical layer; and the mode controller is further configured to: adjust, based on the indication information, at least one of the following parameters of a transmitter and a receiver in the port physical layer: a signal transmission rate or an amplitude of a transmitted signal.

In Implementation 1, the plurality of interface controllers share the same interface physical layer. The mode controller controls, based on the indication information provided by the indicator, the multiplexer to select one of the plurality of interface controllers, to implement an interface protocol of a same type as that of the first device. The plurality of interface controllers share the same interface physical layer, so that a layout area occupied by the interface physical layer in an electronic device can be reduced, which is conducive to implementation of an electronic device with high integration and small size.

Implementation 2 not encompassed by the subject-matter of the claims but considered useful for understanding the invention: The interface circuit includes a plurality of interface controllers, a plurality of port physical layers, a switch group, and a mode controller. The plurality of interface controllers are coupled to first ends of the plurality of port physical layers in a one-to-one correspondence. Second ends of the plurality of port physical layers are coupled to the data transmission end of the interface circuit through a plurality of switches in the switch group in a one-to-one correspondence. An input end of the mode controller is coupled to the interface indication end, an output end of the mode controller is coupled to a control end of the switch group, and the mode controller is configured to control, based on the indication information, any switch in the switch group to be turned on.

In Implementation 2, the plurality of interface controllers are connected to the plurality of port physical layers in a one-to-one correspondence. For example, the plurality of interface controllers includes an HDMI controller, a DP controller, and a USB interface controller, the plurality of port physical layers includes an HDMI port physical layer, a DP port physical layer, and a USB port physical layer, the HDMI controller is coupled to a first end of the HDMI port physical layer, the DP controller is coupled to a first end of the DP port physical layer, and the USB interface controller is coupled to a first end of the USB port physical layer. The switch group includes a plurality of switches. A second end of each port physical layer is coupled to the data transmission end of the interface circuit through one of the switches. Switches coupled to the port physical layers are different. The mode controller controls, based on the indication information of the indicator, any switch in the switch group to be turned on, to connect one of the port physical layers to the data transmission end of the interface circuit.

It should be noted that the controlling any switch in the switch group to be turned on in this embodiment of this application means that the switch is in an on state and the remaining switches are in an off state. For example, when all the switches in the switch group are in an off state, controlling any switch in the switch group to be turned on means turning on one of the switches and keeping the remaining switches in the off state. In another example, when all the switches in the switch group are in an on state, controlling any switch in the switch group to be turned on means keeping one of the switches in the on state and turning off the remaining switches.

Based on Implementation 1 and Implementation 2, the mode controller in this embodiment of this application may be implemented in a plurality of implementations.

In a first possible implementation, the mode controller includes a comparator and a first resistor. A first input end of the comparator is coupled to a ground end, a second input end of the comparator is coupled to the input end of the mode controller, and an output end of the comparator is coupled to the output end of the mode controller. One end of the first resistor is coupled to a power supply end, and the other end of the first resistor is coupled to the second input end of the comparator.

In a second possible implementation, the mode controller includes a comparator and a current source. A first input end of the comparator is coupled to a ground end, a second input end of the comparator is coupled to the input end of the mode controller, and an output end of the comparator is coupled to the output end of the mode controller. One end of the current source is coupled to a power supply end, and the other end of the current source is coupled to the second input end of the comparator.

In a third possible implementation, the indication information is an analog signal, and the mode controller includes an analog-to-digital converter and a first resistor. One end of the first resistor is coupled to a power supply end, and the other end of the first resistor is coupled to an input end of the analog-to-digital converter. A first input end of the analog-to-digital converter is coupled to a ground end, a second input end of the analog-to-digital converter is coupled to the input end of the mode controller, and the analog-to-digital converter generates a digital signal based on the indication information and provides the digital signal to the output end of the mode controller.

In a fourth possible implementation, the indication information is an analog signal, and the mode controller includes an analog-to-digital converter and a current source. One end of the current source is coupled to a power supply end, and the other end of the current source is coupled to an input end of the analog-to-digital converter. A first input end of the analog-to-digital converter is coupled to a ground end, a second input end of the analog-to-digital converter is coupled to the input end of the mode controller, and the analog-to-digital converter generates a digital signal based on the indication information and provides the digital signal to the output end of the mode controller.

In a fifth possible implementation, the indication information is a digital signal, and the mode controller includes a reader. The reader is configured to read the indication information, generate a control signal based on the indication information, and provide the control signal to the input end of the mode controller.

Based on Implementation 1 and Implementation 2, in a possible implementation, the port physical layer includes a transmitter, and the transmitter is configured to transmit data to the first device by using the data transmission apparatus; and the interface circuit further includes a capacitor, a second resistor, and a first switch. A first end of the capacitor is coupled to an output end of the transmitter, and a second end of the capacitor and one end of the second resistor are coupled to the data transmission end of the interface circuit. The other end of the second resistor is coupled to the ground end through the first switch.

Optionally, a quantity of capacitors, a quantity of second resistors, and a quantity of first switches are the same as a quantity of transmitters.

In this embodiment of this application, the capacitor, the second resistor, and the first switch are provided, so that when the interface circuit is used as a data transmit end, both a specification for a direct-current signal coupling mode in an interface protocol and a specification for an alternating-current signal coupling mode in an interface protocol can be satisfied. For example, when the first device transmits data through an interface (such as a DP, a USB3 interface, a USB4 interface, or a new interface) in an alternating-current coupling mode supported by an interface protocol, the first switch may be turned off. When the first device transmits data through an interface (such as an HDMI or a new interface) in a direct-current coupling mode supported by an interface protocol, the first switch may be turned on.

Based on Implementation 1 and Implementation 2, in a possible implementation, the port physical layer further includes a receiver, and the receiver is configured to receive data from the first device by using the data transmission apparatus; and the interface circuit further includes a third resistor, a second switch, a fourth resistor, and a third switch. A first end of the third resistor is coupled to the power supply end through the second switch. A second end of the third resistor, a first end of the fourth resistor, and a receive end of the receiver are all coupled to the data transmission end of the interface circuit. A second end of the fourth resistor is coupled to a common ground through the third switch.

Optionally, a quantity of third resistors, a quantity of second switches, a quantity of fourth resistors, and a quantity of third switches are the same as a quantity of receivers.

In this embodiment of this application, the third resistor, the second switch, the fourth resistor, and the third switch are provided, so that when the interface circuit is used as a data receive end, both a specification for a direct-current signal coupling mode in an interface protocol and a specification for an alternating-current signal coupling mode in an interface protocol can be satisfied. For example, when the first device transmits data through an interface (such as a DP, a USB3 interface, a USB4 interface, or a new interface) in an alternating-current coupling mode supported by an interface protocol, the second switch may be turned off and the third switch may be turned on. When the first device transmits data through an interface (such as an HDMI or a new interface) in a direct-current coupling mode supported by an interface protocol, the second switch may be turned on and the third switch may be turned off.

Based on Implementation 1 and Implementation 2, in a possible implementation, the port physical layer includes at least one transmitter and at least one receiver; and a first transmitter in the at least one transmitter and a first receiver in the at least one receiver are coupled to a same cable in the data transmission apparatus.

According to a second aspect, an embodiment of this application provides an electronic device. The electronic device includes a physical interface and the interface circuit according to the first aspect. The interface circuit is coupled to a data transmission end and the indicator that are in the data transmission apparatus through the physical interface.

In a possible implementation, the interface includes a first connection end and a second connection end. The data transmission end of the interface circuit is coupled to the first connection end. The interface indication end of the interface circuit is coupled to the second connection end.

According to a third aspect, an embodiment of this application provides a data transmission apparatus. The data transmission apparatus is coupled between a first device and a second device and is configured to transmit data between the first device and the second setting. The data transmission apparatus includes: an indicator, coupled to an interface circuit in the first device and configured to provide indication information to the interface circuit. The indication information indicates a data transmission interface protocol of the second device.

In a possible implementation, the data transmission apparatus further includes: a plurality of cables. The plurality of cables is configured to couple the first device to the second device, so that data is transmitted between the first device and the second device through the plurality of cables.

In a possible implementation, the data transmission apparatus further includes a first adapter plug coupled to the first device and a second adapter plug coupled to the second device. The first adapter plug includes a first data transmission end and an interface indication end, a first end of each of the plurality of cables is coupled to the first data transmission end, and the adapter is coupled to the interface indication end. The second adapter plug includes a second data transmission end, and a second end of each of the plurality of cables is coupled to the second data transmission end.

In a possible implementation, the indication information is an analog signal, the indicator includes a fifth resistor, one end of the fifth resistor is coupled to the interface indication end of the first adapter plug, and the other end of the fifth resistor is coupled to a ground end.

In a possible implementation, the indication information is a digital signal, and the indicator includes a register. The register is configured to store data, and the data indicates a protocol type of a data transmission interface in the second device.

According to a fourth aspect, an embodiment of this application provides a data transmission system. The data transmission system includes the electronic device according to the second aspect and the data transmission apparatus according to the third aspect.

According to a fifth aspect, an embodiment of this application provides a data transmission method. The data transmission method is applied to an interface circuit. The interface circuit performs data transmission with a first device by using a data transmission apparatus. The interface circuit includes an interface indication end and a data transmission end. The method includes the following steps: The interface circuit obtains indication information from an indicator of the data transmission apparatus through the interface indication end. The indication information indicates a data transmission interface protocol of the first device. The interface circuit transmits data to the first device through the data transmission end based on the data transmission interface protocol of the first device indicated by the indication information.

Based on the fifth aspect, in a possible implementation, the interface circuit includes a plurality of interface controllers, a multiplexer, a port physical layer, and a mode controller; and that the interface circuit transmits data to the first device through the data transmission end based on the data transmission interface protocol of the first device indicated by the indication information includes that: the mode controller obtains the indication information from the indicator of the data transmission apparatus through the interface indication end, and controls, based on the indication information, the multiplexer to connect a first interface controller in the plurality of interface controllers to the port physical layer, where the first interface controller and the first device have the same data transmission interface protocol; and the interface controller controls the port physical layer to transmit data to the first device through the data transmission end based on the data transmission protocol.

Based on the fifth aspect, in a possible implementation, the method further includes the following step: The mode controller adjusts, based on the indication information, at least one of the following parameters of a transmitter and a receiver in the port physical layer: a signal transmission rate or an amplitude of a transmitted signal.

Based on the fifth aspect, in a possible implementation, the interface circuit includes a plurality of interface controllers, a plurality of port physical layers, a switch group, and a mode controller. The plurality of interface controllers, the plurality of port physical layers, and a plurality of switches in the switch group are coupled in a one-to-one correspondence; and that the interface circuit transmits data to the first device through the data transmission end based on the data transmission interface protocol of the first device indicated by the indication information includes that: the mode controller obtains the indication information from the indicator of the data transmission apparatus through the interface indication end, and controls, based on the indication information, a first switch in the switch group to be turned on; and a first interface controller corresponding to the first switch in the plurality of interface controllers controls a first port physical layer coupled to the first interface controller and the first switch in the plurality of port physical layers to transmit data to the first device through the data transmission end based on the data transmission protocol.

Based on the fifth aspect, in a possible implementation, the indicator is a resistor, and the indication information is an analog signal.

Based on the fifth aspect, in a possible implementation, the indicator is a register, and the indication information is a digital signal.

Based on the fifth aspect, in a possible implementation, before the interface circuit transmits data to the first device, the method further includes that: the interface circuit establishes a connection to the first device in a direct-current coupling mode or an alternating-current coupling mode.

It should be understood that the technical solutions in the second aspect to the fifth aspect of this application are consistent with the technical solution in the first aspect of this application. Advantageous effects achieved in the aspects and the corresponding feasible implementations are similar, and details are not described again.

### BRIEF DESCRIPTION OF DRAWINGS

To describe technical solutions in embodiments of this application more clearly, the following briefly describes the accompanying drawings for describing embodiments of this application. It is clear that the accompanying drawings in the following descriptions show merely some embodiments of this application, and a person of ordinary skill in the art may still derive other drawings from these accompanying drawings without creative efforts.
FIG. 1 is a schematic diagram of a system architecture according to an embodiment of this application;
FIG. 2 is a schematic diagram of a structure of an interface circuit according to an embodiment of this application;
FIG. 3 is a schematic diagram of a structure of an interface chip according to an embodiment of this application;
FIG. 4 is a schematic diagram of a structure of a mode controller according to an embodiment of this application;
FIG. 5 is a schematic diagram of another structure of a mode controller according to an embodiment of this application;
FIG. 6 is a schematic diagram of another structure of a mode controller according to an embodiment of this application;
FIG. 7 is a schematic diagram of another structure of a mode controller according to an embodiment of this application;
FIG. 8 is a schematic diagram of another structure of a mode controller according to an embodiment of this application;
FIG. 9 is a schematic diagram of another structure of an interface circuit according to an embodiment of this application not encompassed by the subject-matter of the claims but considered useful for understanding the invention;
FIG. 10 is a schematic diagram of a structure of a switch group in the interface circuit shown in FIG. 9 according to an embodiment of this application not encompassed by the subject-matter of the claims but considered useful for understanding the invention;
FIG. 11 is a schematic diagram of another structure of a switch group in the interface circuit shown in FIG. 9 according to an embodiment of this application not encompassed by the subject-matter of the claims but considered useful for understanding the invention;
FIG. 12 is a schematic diagram of a peripheral circuit of an interface circuit when an interface is used as a signal transmission interface according to an embodiment of this application;
FIG. 13 is a schematic diagram of an equivalent circuit when an interface is used as a signal transmission interface according to an embodiment of this application;
FIG. 14 is a schematic diagram of another equivalent circuit when an interface is used as a signal transmission interface according to an embodiment of this application;
FIG. 15 is a schematic diagram of a peripheral circuit of an interface circuit when an interface is used as a signal receiving interface according to an embodiment of this application;
FIG. 16 is a schematic diagram of an equivalent circuit when an interface is used as a signal receiving interface according to an embodiment of this application;
FIG. 17 is a schematic diagram of another equivalent circuit when an interface is used as a signal receiving interface according to an embodiment of this application;
FIG. 18a is a schematic diagram of another peripheral circuit of an interface circuit according to an embodiment of this application;
FIG. 18b is a schematic diagram of another peripheral circuit of an interface circuit according to an embodiment of this application;
FIG. 19 is a schematic diagram of another system architecture of a device 101 according to an embodiment of this application; and
FIG. 20 is a flowchart of a data transmission method according to an embodiment of this application.

### DESCRIPTION OF EMBODIMENTS

The following clearly and completely describes the technical solutions in embodiments of this application with reference to the accompanying drawings in embodiments of this application. It is clear that the described embodiments are some but not all of embodiments of this application. All other embodiments obtained by a person of ordinary skill in the art based on embodiments of this application without creative efforts shall fall within the protection scope of this application.

The term "first", "second", or the like mentioned in this specification does not indicate any order, quantity, or importance, but is used only for distinguishing between different components. Likewise, "a/an", "one", or the like is not intended to indicate a quantity limitation either, but is intended to indicate at least one. "Connection", "link" or the like is not limited to a physical or mechanical connection, but may include an electrical connection, whether directly or indirectly. It is equivalent to coupling or communication in a broad sense.

In embodiments of this application, the word "example", "for example", or the like is used to represent giving an example, an illustration, or a description. Any embodiment or design scheme described as an "example" or "for example" in embodiments of this application should not be explained as being more preferred or having more advantages than another embodiment or design scheme. Exactly, use of the word "example", "for example", or the like is intended to present a related concept in a specific manner. In the description of embodiments of this application, unless otherwise stated, "plurality of" means two or more than two. For example, a plurality of interface controllers refers to two or more interface controllers; and a plurality of transmitters refers to two or more transmitters.

The interface in embodiments of this application may be a physical interface, and the physical interface is a connector connected to an external device such as a transmission line or an adapter. The interface circuit in embodiments of this application may include a circuit board or a chip. The interface circuit is coupled to the interface, and data transmission with an external device is implemented through the interface.

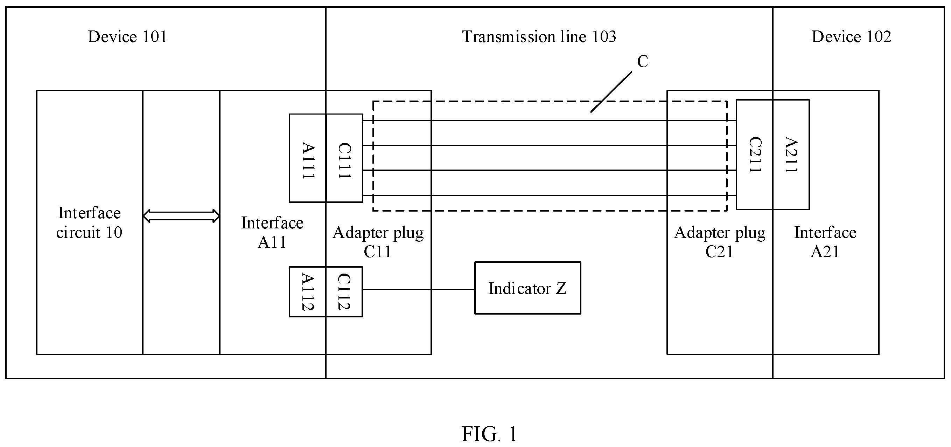

Refer to FIG. 1. FIG. 1 is a schematic diagram of a system architecture according to an embodiment of this application. In FIG. 1, a device 101 and a device 102 are included. The device 101 and the device 102 may include but are not limited to various electronic devices such as a host, a display, a television, a set-top box, an integrated computer (for example, a notebook computer or an integrated desktop computer), a game console, a USB flash drive, or a removable hard disk. The host herein may be a device that integrates components such as a processor and a memory but does not have a display function, and the host can drive a display to run. The device 101 is provided with an interface A11. The device 102 is provided with an interface A21. The device 101 and the device 102 may communicate with each other through the interfaces, to perform data exchange. In a possible implementation, the device 101 and the device 102 are different types of devices. For example, the device 101 is a host, and the device 102 is a display. In another example, the device 101 is a set-top box, and the device 102 is one of a television, a display, or an integrated computer.

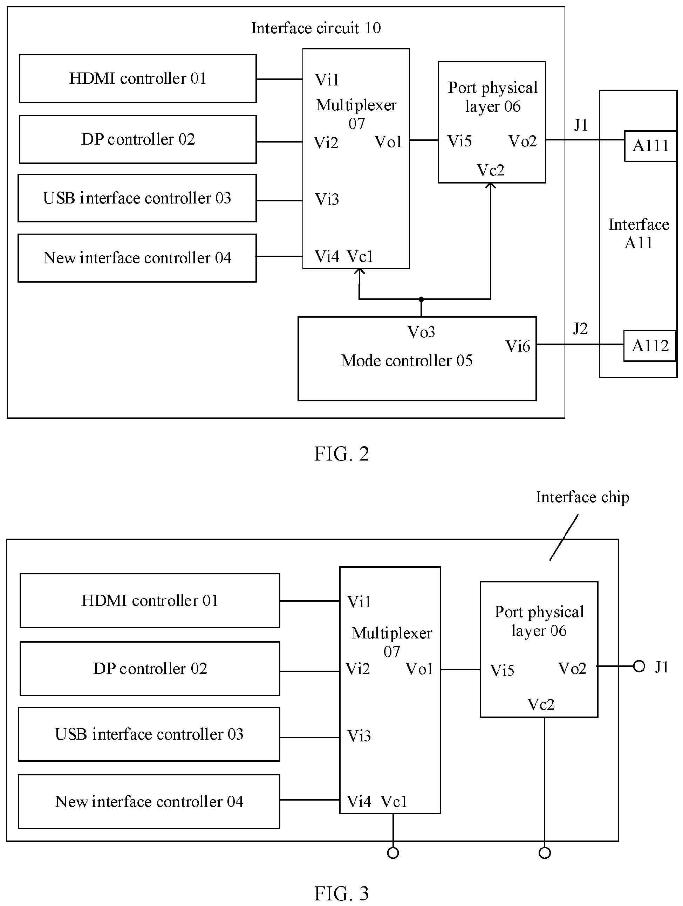

Based on the system architecture shown in FIG. 1, in this embodiment of this application, the interface A21 of the device 102 may be a conventional interface. The conventional interface includes but is not limited to one of the following: a high definition multimedia interface (HDMI, High Definition Multimedia Interface), a display port (DP, DisplayPort), or a universal serial bus (Universal Serial Bus, USB) interface. In addition, the interface A21 of the device 102 may alternatively be a newly specified interface. In this embodiment of this application, this type of interface is referred to as a new interface for short. The new interface may perform communication based on an interface protocol specified by the new interface. The device 101 may configure, based on a type of the interface A21 of the device 102, the interface A11 as an interface matching the device 102. In this embodiment of this application, an interface that can match a plurality of protocol types is referred to as a multi-protocol interface. The matching herein may be understood as: communicating with the device 102 based on the same interface protocol as that of the interface A21 of the device 102. For example, when the interface A21 of the device 102 is a new interface, the device 101 may communicate with the device 102 based on a protocol specified by the new interface. When the interface A21 of the device 102 is an HDMI, the device 101 may communicate with the device 102 through the interface A11 based on an interface protocol of the HDMI. When the interface A21 of the device 102 is a DP, the device 101 may communicate with the device 102 through the interface A11 based on an interface protocol of the DP. Specifically, an interface circuit 10 may be provided in the device 101, and the interface circuit 10 is coupled to the interface A11. The interface circuit 10 may be implemented by software, hardware, or a combination thereof. The interface circuit 10 may include a controller, a programmable logic device (PLC, Programmable Logic Controller), a transistor device, a discrete hardware component, or the like. A plurality of types of interface controllers such as an HDMI, a DP, a USB interface, or a new interface may be provided in the interface circuit 10. The interface circuit 10 in the device 101 enables one of the interface controllers based on the interface type of the device 102, so that the interface A11 matches the interface A21. By providing the interface circuit 10 in the device 101 shown in this embodiment of this application, a same interface can perform data transmission with electronic devices with various interface types. Compared with a conventional electronic device provided with a plurality of types of interfaces, a layout area occupied by the interface in an electronic device is reduced, which is conducive to implementation of an electronic device with high integration and small size. For specific descriptions of the interface circuit 10, refer to the following related descriptions of the embodiments shown in FIG. 2 to FIG. 18b.

The system architecture shown in FIG. 1 further includes a data transmission apparatus. The data transmission apparatus may include but is not limited to a transmission line or an adapter. The interface A11 of the device 101 is connected to the interface A21 of the device 102 by using the data transmission apparatus. A difference between the adapter and the transmission line lies in that a cable for data transmission is provided in the transmission line while no cable is provided in the adapter. Other structures of the adapter and the transmission line are the same. For ease of description, an example in which the data transmission apparatus is a transmission line 103 is used for description in this embodiment of this application. FIG. 1 schematically shows a case in which the device 101 is connected to the device 102 through the transmission line 103. A type of the transmission line or an adapter plug in the adapter in this embodiment of this application usually needs to match a type of an interface of a device connected to the transmission line or the adapter. The matching herein means that an end of the adapter plug can be inserted into the device 101. The transmission line 103 shown in FIG. 1 is used as an example. The transmission line 103 includes an adapter plug C11 and an adapter plug C21. The adapter plug C11 is configured to be connected to the interface A11, and may match the interface A11. The adapter plug C21 is configured to be connected to the interface A21, and may match the interface A21. An example in which the device 101 is a host and the device 102 is a display (with an interface being an HDMI) is used to describe connections between the transmission line 103 and the device 101 and between the transmission line 103 and the device 102 in more detail. As the interface A11 of the device 101 is a multi-protocol interface, a physical appearance of the multi-protocol interface may be different from a physical appearance of any conventional protocol interface. Therefore, a physical appearance of an adapter plug configured to be connected to the interface A11 in the transmission line 103 may be designed as a physical appearance that can be inserted into the interface A11, to implement the connection to the interface A11. An adapter plug configured to be connected to the interface A21 in the transmission line 103 needs to be designed as an adapter plug with a physical appearance of an HDMI type to be inserted into the device 102, to implement the connection to the interface A21. Therefore, the device 101 can perform data transmission with the device 102 through the transmission line 103.

The transmission line 103 in this embodiment of this application may be provided with a plurality of cables C for data transmission. A quantity of the cables C for data transmission may be set based on a conventional interface transmission line protocol. For example, four cables are provided based on a conventional interface transmission line protocol to perform four-way data transmission, or eight cables are provided based on a conventional interface transmission line protocol to perform eight-way data transmission. FIG. 1 schematically shows a case in which the transmission line 103 is provided with four cables C. In addition to the cable for data transmission, an indicator Z is further provided in the transmission line or the adapter in this embodiment of this application. The indicator Z is configured to indicate a type of an interface, in the device 102, connected to the multi-protocol interface.

In the transmission line 103 shown in FIG. 1, the adapter plug C11 connected to the multi-protocol interface may include a data transmission end C111 and an interface indication end C112. The data transmission end C111 is coupled to one end of the cable C, and the interface indication end C112 is coupled to the indicator Z. The adapter plug C21 connected to a conventional interface may include a data transmission end C211. The data transmission end C211 is coupled to the other end of the cable C. The cable C is coupled to the interface A11 through the data transmission end C111 and is coupled to the interface A21 through the data transmission end C211, to implement data transmission between the device 101 and the device 102. The indicator Z is coupled to the interface circuit 10 in the device 101 through the interface indication end C112 and the interface A11. Therefore, the interface circuit 10 can determine an interface type of the device 102 based on a signal outputted by the indicator Z, to communicate with the device 102 based on a same interface protocol as that of the device 102. The interface A11 shown in FIG. 1 may include a connection end A111 and a connection end A112. The connection end A111 is configured to be coupled to the data transmission end C111 in the transmission line 103. The connection end A112 is configured to be coupled to the interface indication end C112 in the transmission line 103. The interface A21 shown in FIG. 1 may include a data transmission end A211. The data transmission end A211 is configured to be coupled to the data transmission end C211 in the adapter plug C21 of the transmission line 103. In a possible implementation of an actual product, the cable C and the indicator Z in the transmission line 103 may be wrapped inside by an insulation layer, not exposed outside. In addition, in the adapter plug C11 of the transmission line 103, the data transmission end C111 and the interface indication end C112 may be integrated together. Similarly, in the interface A11, the connection end A111 and the connection end A112 may be integrated together. In this way, during use, a user may directly insert the adapter plug C11 into the interface A11 without distinguishing the connection ends, thereby improving convenience for the user.

Based on the system architecture shown in FIG. 1, with reference to the embodiments shown in FIG. 2 to FIG. 18b, the following describes in detail a structure of the interface circuit 10, a structure of the indicator provided in the transmission line 103, and working principles of the interface circuit and the indicator in this embodiment of this application.

Still refer to FIG. 2. FIG. 2 is a schematic diagram of a structure of the interface circuit 10 according to an embodiment of this application. The interface circuit 10 may be a module, a chip, a chipset, or a circuit board or component carrying a chip or chipset, which is integrated into a device. In FIG. 2, the interface circuit 10 includes a plurality of interface controllers (an HDMI controller 01, a DP controller 02, a USB interface controller 03, and a new interface controller 04), a multiplexer 07, a mode controller 05, and a port physical layer (PHY, Port Physical Layer) 06. In this embodiment of this application, the plurality of interface controllers, the multiplexer 07, and the port physical layer 06 may be integrated into one or more chips. The one or more chips may be considered as a chipset. Optionally, the plurality of interface controllers, the multiplexer 07, and the port physical layer 06 may be integrated into a same chip. When the plurality of interface controllers, the multiplexer 07, and the port physical layer 06 are integrated into a same chip, the chip is also referred to as an interface chip. As shown in FIG. 3, the interface chip may be integrated into a system on chip (Soc, System on chip) in the electronic device 101. In addition, the mode controller 05 may be integrated into the interface chip, or may be provided outside the interface chip. Moreover, the interface circuit 10 may be independently packaged and sold. The interface circuit 10 further includes a data transmission end J1 and an interface indication end J2. The signal connection end J1 is coupled to the plurality of cables in the transmission line 103 through the connection end A111 of the interface A11. The interface indication end J2 is coupled to the indicator Z in the transmission line 103 through the connection end A112 of the interface A11. The plurality of interface controllers may include the HDMI controller 01, the DP controller 02, the USB interface controller 03, the new interface controller 04, and another known or unknown interface controller that are shown in FIG. 2. In addition, a memory or register (not shown in the figure) may be further provided in the interface circuit 10, to store a software program or code required for running the foregoing interface controllers. The foregoing interface controllers may call all or some computer programs stored in the memory or register, to implement interfaces of corresponding types. It should be noted that the plurality of interface controllers runs different computer programs, and each computer program run by each interface controller may be separately stored in the memory or register.

In FIG. 2, the multiplexer 07 includes a first end Vi1, a second end Vi2, a third end Vi3, and a fourth end Vi4. The HDMI controller 01 is coupled to the first end Vi1. The DP controller 02 is coupled to the second end Vi2. The USB interface controller 03 is coupled to the third end Vi3. The new interface controller 04 is coupled to the fourth end Vi4. A fifth end Vo1 of the multiplexer 07 is coupled to a first end Vi5 of the port physical layer 06. A second end Vo2 of the port physical layer 06 is coupled to the data transmission end J1 of the interface circuit 10, to be coupled to the connection end A111 of the interface A11. In addition, the multiplexer 07 further includes a control end Vc1, and the port physical layer 06 further includes a control end Vc2. An output end Vo3 of the mode controller 05 is coupled to the control end Vc1 of the multiplexer 07 and the control end Vc2 of the port physical layer 06 respectively. A signal input end Vi6 of the mode controller 05 is coupled to the interface indication end J2 of the interface circuit 10, to be coupled to the connection end A112 of the interface A11.

The multiplexer 07 may be an X-to-1 multiplexer. The multiplexer 07 connects one of the plurality of interface controllers to the port physical layer 06 based on the control of a signal inputted by the mode controller 05. For example, if the interface controllers include an HDMI controller, a DP controller, a USB interface controller, and a new interface controller, the multiplexer may be a 4-to-1 multiplexer. In addition, a control signal inputted by the control end Vc1 of the multiplexer may include two control bits. For example, "00" indicates that the HDMI controller 01 is selected, "01" indicates that the DP controller 02 is selected, "10" indicates that the USB interface controller 03 is selected, and "11" indicates that the new interface controller 04 is selected.

The port physical layer 06 is configured to transmit and receive a signal. The port physical layer 06 may include a plurality of transmitters TX (or a plurality of receivers RX). The port physical layer 06 may encode, according to an interface protocol rule of an interface protocol used by the device 102, data sent by one of the plurality of controllers, and convert the encoded data into an analog signal for transmission (or may decode, according to an interface protocol rule of an interface protocol used by the device 102, an analog signal provided by the transmission line 103, and provide decoded data to one of the plurality of controllers). In the interface circuit 10 shown in FIG. 2, the plurality of interface controllers reuse a transmitter TX (or a receiver RX) in the port physical layer 06 to implement a multi-protocol interface. Parameter settings of the transmitter TX (or the receiver RX) are different due to different interface protocols. To implement the multi-protocol interface, the port physical layer 06 may receive a control signal from the mode controller 05 through the control end Vc2, and adjust a parameter of the transmitter TX (or the receiver RX) based on the control signal. The parameter of the transmitter TX (or the receiver RX) may include but is not limited to a signal transmission rate or an amplitude of a transmitted signal. In this embodiment of this application, a manner for adjusting the parameter of the transmitter TX (or the receiver RX) may be the same as a selection manner of the multiplexer 07. For example, when the interface A11 can implement an HDMI protocol, a DP protocol, a USB interface protocol, and a new interface protocol, the control signal inputted by the control end Vc2 of the port physical layer 06 may include two control bits. In this case, "00" indicates that the parameter of the transmitter TX (or the receiver RX) is adjusted to a parameter of the HDMI protocol, "01" indicates that the parameter of the transmitter TX (or the receiver RX) is adjusted to a parameter of the DP protocol, "10" indicates that the parameter of the transmitter TX (or the receiver RX) is adjusted to a parameter of the USB interface protocol, and "11" indicates that the parameter of the transmitter TX (or the receiver RX) is adjusted to a parameter of the new interface protocol. It should be noted that only a controller of one interface protocol type is provided in a conventional interface circuit, and only physical hardware such as a transmitter or a receiver is provided in a port physical layer in the conventional interface circuit. The physical hardware is configured to implement only one interface protocol type, and there is no multi-protocol multiplexing. Hardware devices included in the port physical layer 06 in this embodiment of this application may be the same as or similar to the physical hardware included in the conventional interface circuit, for example, include a transmitter, a receiver, and discrete components such as a capacitor and a resistor. In addition, because the port physical layer 06 in this embodiment of this application can be reused based on a plurality of types of interface protocols, in another possible implementation, the port physical layer 06 may further include a multiplexer 07 and a mode controller 06. In this embodiment of this application, the multiplexer 07 and the mode controller 06 are provided outside the port physical layer 06 for description.

The mode controller 05 may be a programmable logic device or a discrete device. The mode controller 05 controls, based on a signal inputted by the connection end A112 of the interface A11, the multiplexer 07 to couple one of the plurality of interface controllers to the port physical layer 06. In addition, the mode controller 05 may further control, based on the signal inputted by the connection end A112 of the interface A11, a corresponding circuit unit in the port physical layer 06 to operate. It should be noted that the mode controller 05 in this embodiment of this application needs to cooperate with the indicator Z in the transmission line 103 shown in FIG. 1, to detect an interface type of the device 102 connected to the other end of the transmission line 103. Therefore, a structure of the mode controller 05 is associated with a structure of the indicator Z in the transmission line 103. The following describes in detail the structure of the mode controller 05 and the structure of the indicator in this embodiment of this application in several possible implementations.

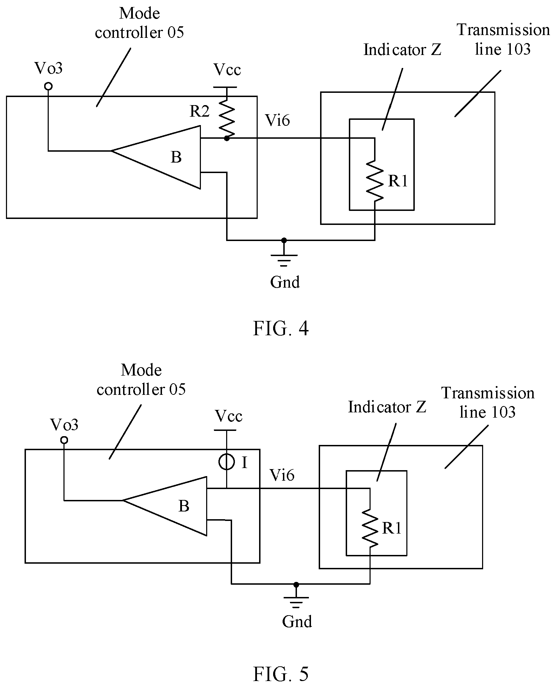

Refer to FIG. 4. FIG. 4 is a schematic diagram of first structures of the mode controller 05 and the indicator Z. In FIG. 4, the indicator may be a resistor R1. Different resistance values indicate different protocol interfaces. For example, a resistance value indicating an HDMI may be 100 KΩ, a resistance value indicating a DP may be 200 KΩ, a resistance value indicating a USB interface may be 800 KΩ, and a resistance value indicating a new interface may be 1600 KΩ. The mode controller 05 may include a comparator B. A first input end of the comparator B is coupled to a common ground Gnd. A second input end of the comparator B is coupled to the signal input end Vi6 of the mode controller 05. An output end of the comparator B is coupled to the output end Vo3 of the mode controller 05. The mode controller 05 shown in FIG. 4 further includes a resistor R2. A resistance value of the resistor R2 may be, for example, 400 KΩ. One end of the resistor R2 is coupled to the second input end of the comparator B, and the other end of the resistor R2 is configured to be connected to a power supply end Vcc of the mode controller 05. When the adapter plug C11 of the transmission line 103 is inserted into the interface A11, the connection end A112 of the interface A11 is coupled to the interface indication end C112 in the adapter plug C11. The resistor R1 is connected in parallel between the first input end and the second input end of the comparator B. In this case, a voltage at the second input end of the comparator B is Vcc*(R1/(R1+R2)). The comparator B may be a multi-threshold comparator. That is, a plurality of thresholds may be set in the comparator B. The comparator B compares the voltage value of the second input end with the plurality of thresholds, and outputs a control signal based on a comparison result. Assuming that the device 101 can implement interfaces of four protocols, three thresholds may be set in the comparator B, and the output end of the comparator B outputs a two-bit signal. It may be understood that a quantity of thresholds set in the comparator B and a quantity of outputted bits may be determined based on a quantity of implemented protocol types. This is not limited in embodiments of this application.

Based on the schematic diagram of the first structures of the mode controller 05 and the indicator Z shown in FIG. 4, the following describes in detail a working principle of the interface circuit 10 shown in FIG. 2 by using an example in which the resistance value indicating the HDMI is 100 KΩ, the resistance value indicating the DP is 200 KΩ, the resistance value indicating the USB interface is 800 KΩ, and the resistance value indicating the new interface may be 1600 KΩ in the indicator Z. In this case, the three thresholds 1/4*Vcc, 1/2*Vcc, and 3/4*Vcc may be set in the mode controller 05. Assuming that a voltage at the second input end of the comparator B is 1/5*Vcc after the resistor R1 is connected to the first input end and the second input end of the comparator B, the voltage value is less than any threshold. In this case, the comparator B can output a control signal "00". The control signal "00" is inputted to the control end Vc1 of the multiplexer 07 and the control end Vc2 of the port physical layer 06 respectively, so that a path is formed between the HDMI controller 01 and the port physical layer 06. In addition, a parameter of the transmitter TX (or the receiver RX) in the port physical layer 06 is set to a parameter of an HDMI protocol, so that data transmission is performed between the device 101 and the device 102 based on the HDMI protocol. Assuming that a voltage at the second input end of the comparator B is 1/3*Vcc after the resistor R1 is connected to the first input end and the second input end of the comparator B, the voltage value is greater than 1/4*Vcc and less than 1/2*Vcc. In this case, the comparator B can output a control signal "01". The control signal "01" is inputted to the control end Vc1 of the multiplexer 07 and the control end Vc2 of the port physical layer 06 respectively, so that a path is formed between the DP controller 02 and the port physical layer 06. In addition, a parameter of the transmitter TX (or the receiver RX) in the port physical layer 06 is set to a parameter of a DP protocol, so that data transmission is performed between the device 101 and the device 102 based on the DP protocol. Assuming that a voltage at the second input end of the comparator B is 2/3*Vcc after the resistor R1 is connected to the first input end and the second input end of the comparator B, the voltage value is greater than 1/2*Vcc and less than 3/4*Vcc. In this case, the comparator B can output a control signal "10". The control signal "10" is inputted to the control end Vc1 of the multiplexer 07 and the control end Vc2 of the port physical layer 06 respectively, so that a path is formed between the USB interface controller 03 and the port physical layer 06. In addition, a parameter of the transmitter TX (or the receiver RX) in the port physical layer 06 is set to a parameter of a USB interface protocol, so that data transmission is performed between the device 101 and the device 102 based on the USB interface protocol. Assuming that a voltage at the second input end of the comparator B is 4/5*Vcc after the resistor R1 is connected to the first input end and the second input end of the comparator B, the voltage value is greater than 3/4*Vcc. In this case, the comparator B can output a control signal "11". The control signal "11" is inputted to the control end Vc1 of the multiplexer 07 and the control end Vc2 of the port physical layer 06 respectively, so that a path is formed between the new interface controller 04 and the port physical layer 06. In addition, a parameter of the transmitter TX (or the receiver RX) in the port physical layer 06 is set to a parameter of a new interface protocol, so that data transmission is performed between the device 101 and the device 102 based on the new interface protocol.

In the structure of the mode controller 05 shown in FIG. 4, the voltage at the second input end of the comparator B varies according to a resistance value of the resistor R1 due to voltage division by the resistor. In a second possible implementation, the voltage at the second input end varies according to a resistance value of the resistor R1 by passing a current outputted from a fixed current source through the resistor. Details are shown in FIG. 5. In FIG. 5, the indicator Z includes a resistor R1. Different resistance values indicate different protocol interfaces. Specifically, this resistor R1 is the same as the resistor R1 in FIG. 4, and details are not described herein again. Different from the structure of the mode controller 05 shown in FIG. 4, in FIG. 5, the mode controller 05 further includes a current source I in addition to the comparator B. An input end of the current source I is coupled to the power supply end Vcc, and an output end is coupled to the second input end of the comparator B. In other words, the resistor in FIG. 4 is replaced with the current source in FIG. 5, and other components and a connection relationship between the components are the same as those shown in FIG. 4. Details are not described herein. In specific operation, a current generated by the current source flows to the common ground Gnd through the resistor R1. In this case, a voltage at the second input end of the comparator B is R1*I. As different resistance values indicate different interfaces, for different interface types, voltages inputted to the second input end of the comparator B are different. By setting a reference voltage value of the comparator B, the mode controller 05 can control the multiplexer 07 and the port physical layer 06.

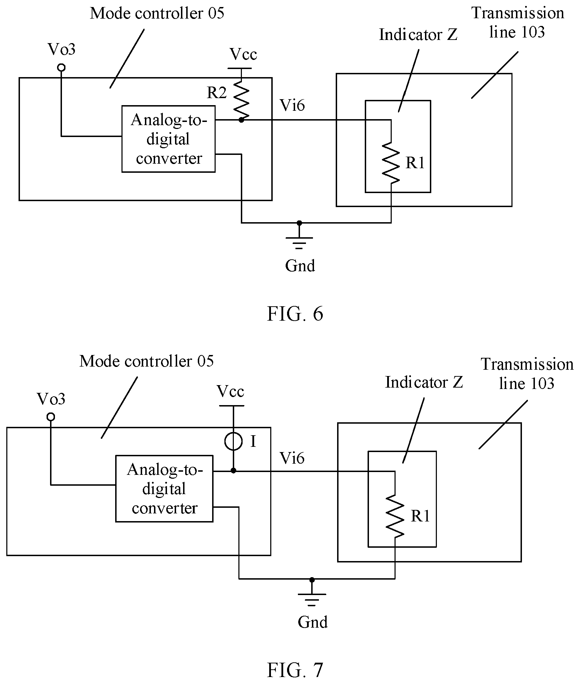

In the mode controller 05 shown in FIG. 4 and FIG. 5, conversion between an input signal and an output signal is implemented by providing the comparator B. In another possible implementation, the comparator B may be replaced with an analog-to-digital converter (ADC, Analog-to-Digital Converter). For other components included in the mode controller 05 and a connection relationship between the components, refer to the components in the mode controller 05 and the connection relationship between the components shown in FIG. 4 or FIG. 5. Details are not described herein again. Circuit structures in which the comparator B is replaced with the ADC are shown in FIG. 6 and FIG. 7. The following describes a working principle of the mode controller 05 by using the circuit structure of the mode controller 05 shown in FIG. 6 as an example. First, a conversion relationship between an input analog signal and an output digital signal may be preset in the ADC. The conversion relationship is implemented based on an internal circuit design of the ADC. After the resistor R1 is connected to a first input end and a second input end of the ADC, a voltage value of the second input end of the ADC is obtained. The voltage value is converted into a digital signal by the ADC to control the multiplexer 07 and the port physical layer 06.

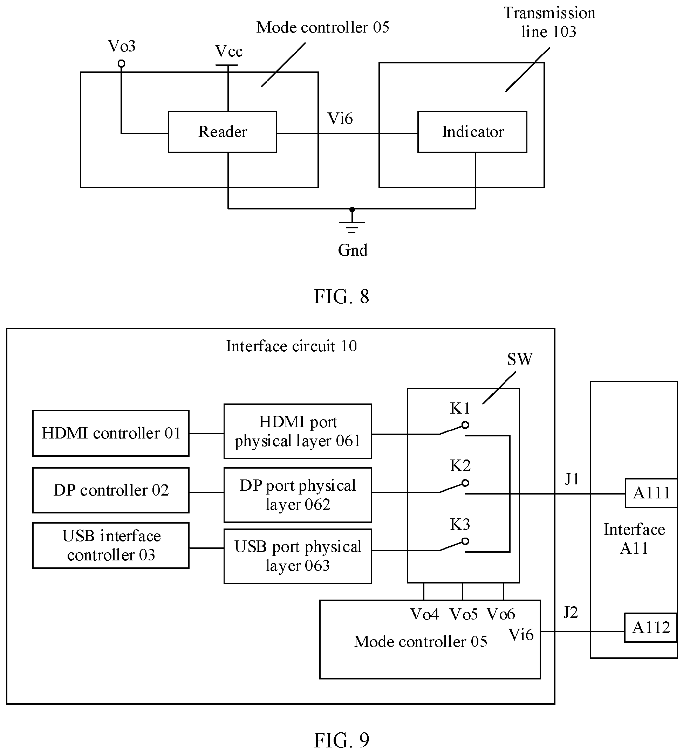

In the structures of the indicator Z shown in FIG. 4 to FIG. 7, the indicator Z is a resistor. An interface type of the peer device 102 is identified through voltage division by the resistor or through a fixed current. In another possible implementation, the indicator Z may be a register. The register stores a value indicating an interface type. Assuming that there are four interface types, two bits may be used in the register to indicate the interface types. For example, "00" indicates the HDMI, "01" indicates the DP, "10" indicates the USB interface, and "11" indicates the new interface. In addition, when more types of interfaces are required, more bits may be added to the register. When the indicator Z is a register, a reader may be provided in the mode controller 05. The reader is configured to read data stored in the register. The reader may be a logic device. A ground end of the reader is coupled to the common ground Gnd. A signal reading end of the reader is coupled to the signal input end Vi6 of the mode controller 05. An output end of the reader is coupled to the output end Vo3 of the mode controller 05. A power supply end of the reader is coupled to the power supply end Vcc of the mode controller 05. When the adapter plug C11 of the transmission line 103 is inserted into the interface A11, a connection relationship between the indicator Z and the mode controller 05 is shown in FIG. 8. In this case, the power supply end Vcc of the mode controller 05 is configured to input a power supply voltage from the outside, the output end Vo3 of the mode controller 05 is coupled to the control ends of the multiplexer 07 and the port physical layer 06, the input end Vi6 of the mode controller 05 is coupled to an output end of the indicator Z through the connection end A112, and a ground end of the indicator Z and a ground end of the indicator Z are together coupled to the common ground Gnd of the interface circuit 10. In the implementation shown in FIG. 8, the mode controller 05 may pre-store a correspondence table among data stored in the register, an interface type, and a control signal. When the adapter plug C11 of the transmission line 103 is inserted into the interface A11, the mode controller 05 may read data stored in the indicator Z, convert the read data into a control signal based on the correspondence table, and input the control signal to the control end Vc1 of the multiplexer. Therefore, the multiplexer 07 forms a path between one of the interface controllers and the port physical layer 06 based on the control signal.

A port physical layer 06 is provided in the interface circuit 10 shown in FIG. 2 to FIG. 8. A plurality of controllers reuse the port physical layer 06. In another possible implementation, the interface circuit may be provided with a plurality of port physical layers 06, and each port physical layer 06 supports a protocol interface. The following provides a detailed description by using an example in which the interface circuit is configured to implement an interface based on an HDMI protocol, a DP protocol, and a USB interface protocol. Still refer to FIG. 9. FIG. 9 is a schematic diagram of another structure of the interface circuit 10 according to an embodiment of this application not encompassed by the subject-matter of the claims but considered useful for understanding the invention. In FIG. 9, an HDMI controller 01, a DP controller 02, a USB interface controller 03, an HDMI port physical layer 061, a DP port physical layer 062, and a USB port physical layer 063 are included. An output end of the HDMI controller 01 is coupled to the HDMI port physical layer 061. An output end of the DP controller 02 is coupled to the DP port physical layer 062. An output end of the USB interface controller 03 is coupled to the USB port physical layer 063. In addition, in FIG. 9, a switch group SW, a mode controller 05, and an interface A11 are further included. For a specific structure of the interface A11, refer to the related description of the interface A11 in FIG. 1, and details are not described herein again. The switch group SW includes a switch K1, a switch K2, and a switch K3. A first end of the switch K1 is coupled to an output end of the HDMI port physical layer 061. A first end of the switch K2 is coupled to an output end of the DP port physical layer 062. A first end of the switch K3 is coupled to an output end of the USB port physical layer 063. A second end of the switch K1, a second end of the switch K2, and a second end of the switch K3 are all coupled to the data transmission end J1 of the interface circuit 10, to be coupled to the connection end A111 of the interface A11. The mode controller 05 includes a plurality of output ends. An output end Vo4 is configured to control the switch K1 to be turned on or off. An output end Vo5 is configured to control the switch K2 to be turned on or off. An output end Vo6 is configured to control the switch K3 to be turned on or off. The input end Vi6 of the mode controller 05 is coupled to the interface indication end J2 of the interface circuit 10, to be coupled to the connection end A112 of the interface A11. For a detailed structure of each port physical layer shown in FIG. 9 and a detailed structure of the port physical layer 06 shown in FIG. 2, refer to the related description of the port physical layer 06 shown in FIG. 2, and details are not described herein again. It should be noted that each port physical layer shown in FIG. 9 is dedicated to an interface protocol, a parameter of a transmitter (or a receiver) in each port physical layer corresponds to an interface protocol parameter, and the parameter does not need to be changed from time to time. Therefore, each port physical layer shown in FIG. 9 does not need to be coupled to the output end of the mode controller 05. In addition, the mode controller 05 shown in FIG. 9 may include a digital-to-analog converter or a reader based on a type of the indicator Z in the cable C. When the mode controller 05 includes a digital-to-analog converter, components included in the mode controller 05 and a connection relationship between the output end and each component are the same as those of the mode controller 05 shown in FIG. 7 to FIG. 9. In this case, the digital-to-analog converter converts an analog voltage signal, inputted by the input end, into a three-bit digital signal, and outputs the three-bit digital signal through the output end Vo4, the output end Vo5, and the output end Vo6 respectively, to control on-off states of the switch K1, the switch K2, and the switch K3. For example, "100" indicates that the switch K1 is turned on, "010" indicates that the switch K2 is turned on, and "001" indicates that the switch K3 is turned on. In addition, the digital-to-analog converter may alternatively convert an analog voltage signal, inputted by the input end, into a two-bit digital signal. For example, "00" indicates that the switch K1 is turned on, "01" indicates that the switch K2 is turned on, and "10" indicates that the switch K3 is turned on. In this case, the mode controller 05 may be provided with only the output end Vo4 and the output end Vo5, without providing the output end Vo6. This case is not shown in the figure. When the mode controller 05 includes a reader, components included in the mode controller 05 and a connection relationship between the output end and each component are the same as those of the mode controller 05 shown in FIG. 8. In this case, the reader converts read data into a three-bit digital signal, and outputs the three-bit digital signal through the output end Vo4, the output end Vo5, and the output end Vo6 respectively, to control on-off states of the switch K1, the switch K2, and the switch K3. It should be noted that

FIG. 9 schematically shows a case in which there are three types of controllers, three corresponding types of port physical layers, and a switch group SW including a switch K1, a switch K2, and a switch K3. A type and a quantity of controllers included in the interface circuit 10 are not specifically limited in embodiments of this application, and are set based on requirements of an application scenario. Correspondingly, a quantity of port physical layers and a quantity of switches included in the switch group SW are not specifically limited, and are set based on a type and a quantity of controllers. Correspondingly, a quantity of bits of the digital signal outputted by the mode controller 05 is also set based on a quantity of switches included in the switch group SW. For example, the interface circuit 10 may further include a new interface controller. In this case, a new interface port physical layer is further required to be provided in the interface circuit 10. Similarly, a switch K4 may be further provided in the switch group SW, and the digital signal outputted by the mode controller 05 may be further, for example, four bits.

As shown in FIG. 9, the switch in the switch group SW may be an analog switch. The switch group SW may be specifically implemented in the following three possible implementations.

In a first possible implementation not encompassed by the subject-matter of the claims but considered useful for understanding the invention, the switch K1, the switch K2, and the switch K3 are single-pole single-throw switches, as shown in FIG. 9.

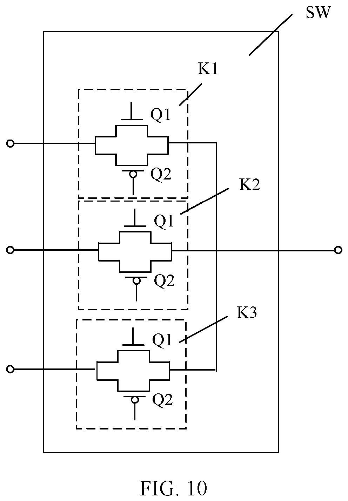

In a second possible implementation not encompassed by the subject-matter of the claims but considered useful for understanding the invention, each of the switch K1, the switch K2, and the switch K3 includes a plurality of transistors, as shown in FIG. 10. Specifically, each switch is provided with a transistor Q1 and a transistor Q2. The transistor Q1 may be an NMOS transistor, and the transistor Q2 may be a PMOS transistor. Alternatively, the transistor Q1 may be a PMOS transistor, and the transistor Q2 may be an NMOS transistor. A connection relationship between the transistors included in each switch is described by using an example in which the transistor Q1 is an NMOS transistor and the transistor Q2 is a PMOS transistor. A first electrode of the transistor Q1, a first electrode of the transistor Q2, and the output end of the HDMI port physical layer 06 are coupled together. Both a second electrode of the transistor Q1 and a second electrode of the transistor Q2 are coupled to the connection end A111 of the interface A11. The first electrode of the transistor Q1 and the second electrode of the transistor Q2 may be drains. The second electrode of the transistor Q1 and the first electrode of the transistor Q2 may be sources. The output end Vo4 of the mode controller 05 is coupled to a gate of a transistor Q1 in the switch K1. The output end Vo4 of the mode controller 05 is coupled to a gate of a transistor Q2 in the switch K1 through an inverter (not shown in the figure). The output end Vo5 of the mode controller 05 is coupled to a gate of a transistor Q1 in the switch K2. The output end Vo5 of the mode controller 05 is coupled to a gate of a transistor Q2 in the switch K2 through an inverter (not shown in the figure). The output end Vo6 of the mode controller 05 is coupled to a gate of a transistor Q1 in the switch K3. The output end Vo6 of the mode controller 05 is coupled to a gate of a transistor Q2 in the switch K3 through an inverter (not shown in the figure). When the mode controller 05 determines, based on information indicated by the indicator Z (for a specific manner of determining the information indicated by the indicator Z, refer to the related descriptions in the embodiments shown in FIG. 4 to FIG. 8) in the connected transmission line, that an interface protocol type used by the peer device 102 is an HDMI, the output end Vo4 of the mode controller 05 outputs a high-level signal, the output end Vo5 outputs a low-level signal, and the output end Vo6 outputs a low-level signal. In this case, the transistor Q1 and the transistor Q2 in the switch K1 are turned on, the output end of the HDMI port physical layer 06 is connected to the connection end A111 of the interface A11, and the device 101 may communicate with the device 201 based on the HDMI protocol.

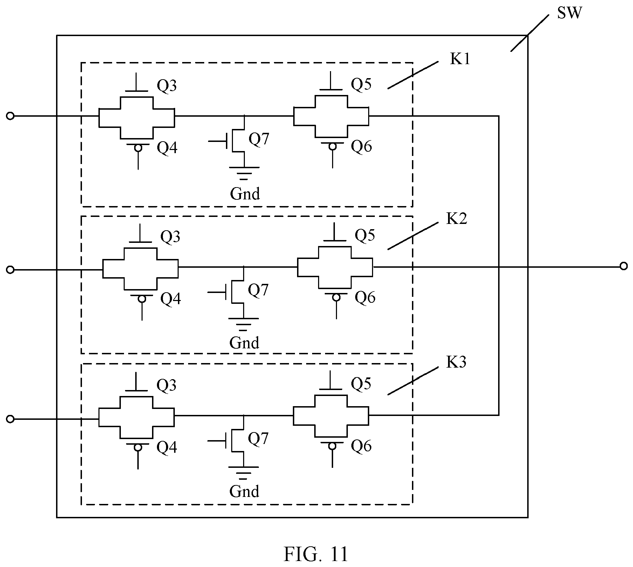

In a third possible implementation not encompassed by the subject-matter of the claims but considered useful for understanding the invention, each of the switch K1, the switch K2, and the switch K3 may include more transistors, as shown in FIG. 11. Specifically, each switch is provided with a transistor Q3, a transistor Q4, a transistor Q5, a transistor Q6, and a transistor Q7. The transistor Q3, the transistor Q5, and the transistor Q7 may be NMOS transistors, and the transistor Q4 and the transistor Q6 may be PMOS transistors. Alternatively, the transistor Q3, the transistor Q5, and the transistor Q7 may be PMOS transistors, and the transistor Q4 and the transistor Q6 may be NMOS transistors. A connection relationship among the transistors included in each switch is described by using an example in which the transistor Q3, the transistor Q5, and the transistor Q7 are NMOS transistors and the transistor Q4 and the transistor Q6 are PMOS transistors. A first electrode of the transistor Q3, a first electrode of the transistor Q4, and the output end of the HDMI port physical layer 06 are coupled together. A second electrode of the transistor Q3, a second electrode of the transistor Q4, a first electrode of the transistor Q5, a first electrode of the transistor Q6, and a first electrode of the transistor Q7 are coupled together. Both a second electrode of the transistor Q5 and the first electrode of the transistor Q6 are coupled to the connection end A111 of the interface A11. A second electrode of the transistor Q7 is coupled to the common ground. The first electrode of the transistor Q3, the second electrode of the transistor Q4, the first electrode of the transistor Q5, the second electrode of the transistor Q6, and the first electrode of the transistor Q7 may be drains, and the second electrode of the transistor Q3, the first electrode of the transistor Q4, the second electrode of the transistor Q5, the first electrode of the transistor Q6, and the second electrode of the transistor Q7 may be sources. Alternatively, the first electrode of the transistor Q3, the second electrode of the transistor Q4, the first electrode of the transistor Q5, the second electrode of the transistor Q6, and the first electrode of the transistor Q7 may be sources, and the second electrode of the transistor Q3, the first electrode of the transistor Q4, the second electrode of the transistor Q5, the first electrode of the transistor Q6, and the second electrode of the transistor Q7 may be drains. The output end Vo4 of the mode controller 05 is coupled to a gate of a transistor Q3, a gate of a transistor Q5, and a gate of a transistor Q7 that are in the switch K1. The output end Vo4 of the mode controller is coupled to a gate of a transistor Q4 and a gate of a transistor Q6 that are in the switch K1 through an inverter (not shown in the figure). The output end Vo5 of the mode controller 05 is coupled to a gate of a transistor Q3, a gate of a transistor Q5, and a gate of a transistor Q7 that are in the switch K2. The output end Vo5 of the mode controller is coupled to a gate of a transistor Q4 and a gate of a transistor Q6 that are in the switch K2 through an inverter (not shown in the figure). The output end Vo6 of the mode controller 05 is coupled to a gate of a transistor Q3, a gate of a transistor Q5, and a gate of a transistor Q7 that are in the switch K3. The output end Vo6 of the mode controller 05 is coupled to a gate of a transistor Q4 and a gate of a transistor Q6 that are in the switch K3 through an inverter (not shown in the figure). When the mode controller 05 determines, based on information indicated by the indicator Z (for a specific manner of determining the information indicated by the indicator Z, refer to the related descriptions in the embodiments shown in FIG. 4 to FIG. 8) in the connected transmission line, that an interface protocol type used by the peer device 102 is an HDMI, the output end Vo4 of the mode controller 05 outputs a high-level signal, the output end Vo5 outputs a low-level signal, and the output end Vo6 outputs a low-level signal. In this case, the transistors in the switch K1 are turned on, the output end of the HDMI port physical layer 06 is connected to the connection end A111 of the interface A11, and the device 101 may communicate with the device 201 based on the HDMI protocol.

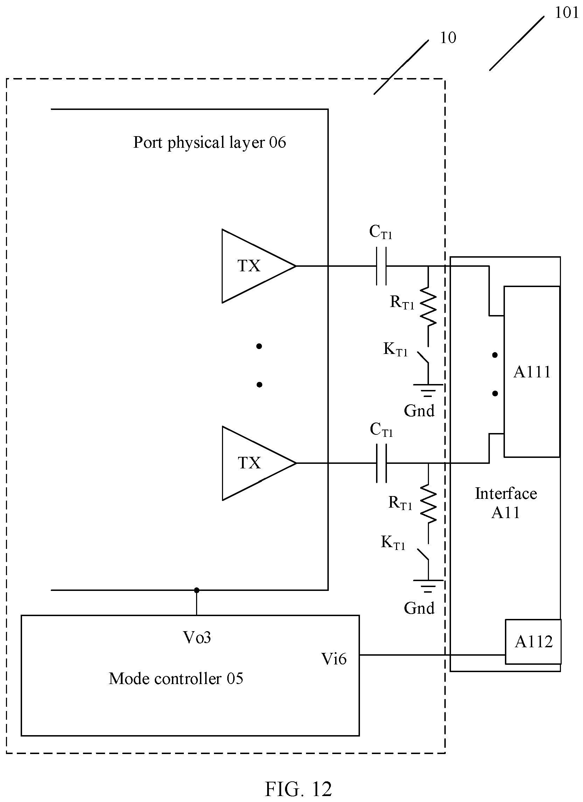

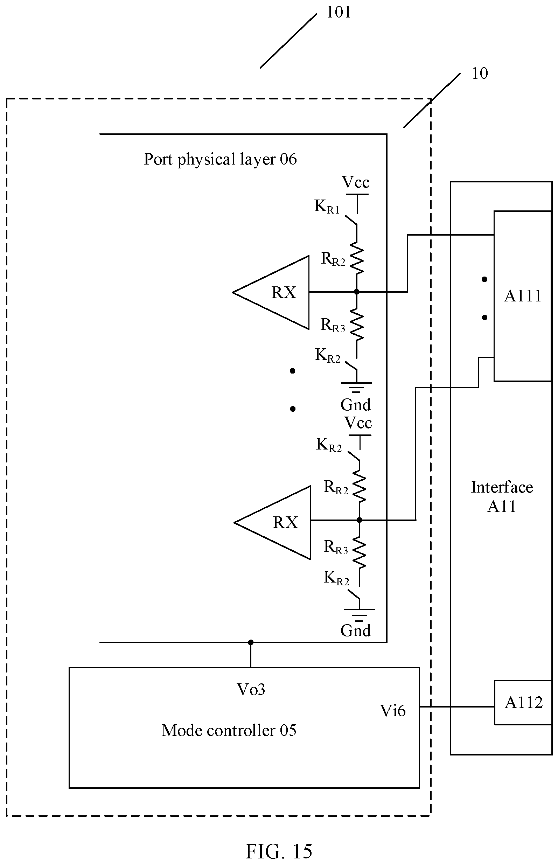

Based on the structure and working principle of each circuit component in the foregoing interface circuit 10, in this embodiment of this application, the interface A11 shown in FIG. 1 and FIG. 2 may be a signal transmission interface. In this case, the device 101 sends data to the device 102 through the interface A11. In addition, the interface A11 may alternatively be a signal receiving interface. In this case, the device 101 receives data from the device 102 through the interface A11. It should be noted that, for interfaces of some protocol types, based on protocol specifications, the signal transmission interface and the signal receiving interface use different peripheral circuits. In addition, in this embodiment of this application, interfaces of different protocol types support different signal coupling modes. For example, the HDMI supports direct-current signal coupling, and the DP supports alternating-current signal coupling. To enable a same interface to adapt to a plurality of different protocols, the interface circuit in this embodiment of this application further includes a peripheral circuit, so that the interface A11 can transmit not only a direct-current signal specified in, for example, the HDMI protocol, but also an alternating-current signal specified in, for example, the DP protocol. It should be noted that the peripheral circuit described herein may be understood as a circuit other than the plurality of interface controllers, the multiplexer 07, the mode controller 05, and the port physical layer 06, and may include but is not limited to a capacitor, a switch, a resistor, and the like. The peripheral circuit of the signal transmission interface is different from the peripheral circuit of the signal receiving interface. The following provides a detailed description by using the embodiments shown in FIG. 12 to FIG. 17. FIG. 12 to FIG. 14 are schematic diagrams of peripheral circuits when the interface A11 shown in FIG. 1 is used as a signal transmission interface. FIG. 15 to FIG. 17 are schematic diagrams of peripheral circuits when the interface A11 shown in FIG. 1 is used as a signal receiving interface.

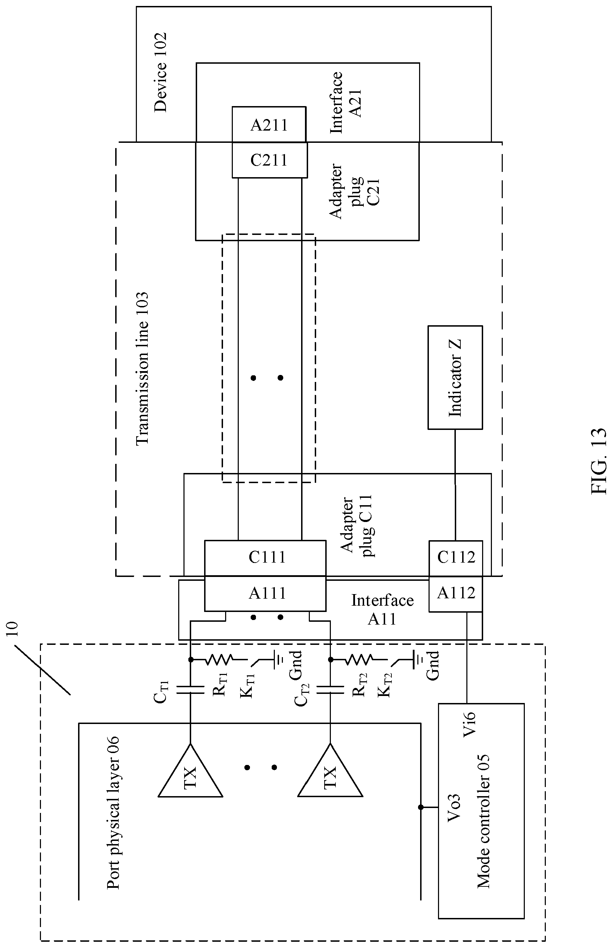

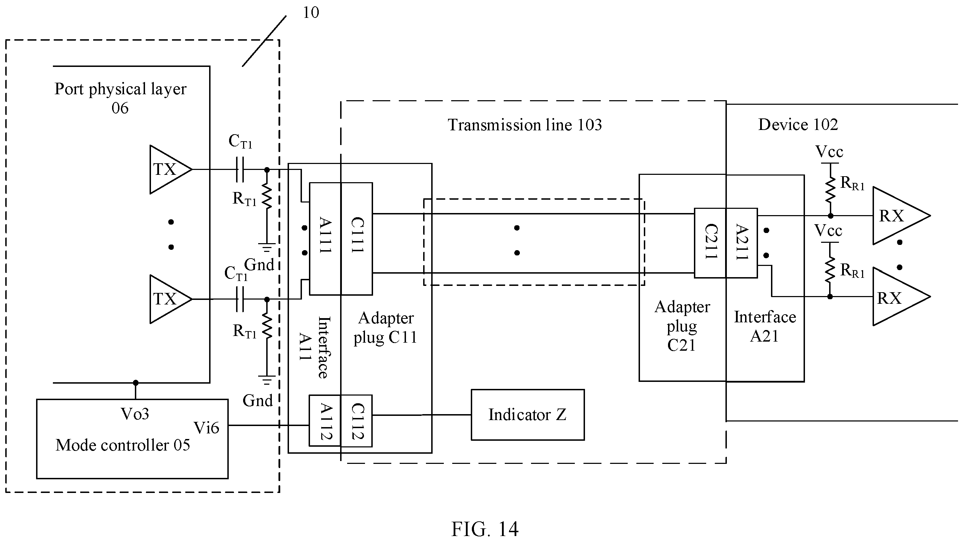

Refer to FIG. 12. In FIG. 12, the interface circuit 10 further includes a plurality of capacitors C_{T1}, a plurality of resistors R_{T1}, and a plurality of switches K_{T1}. A quantity of capacitors C_{T1}, a quantity of resistors R_{T1}, and a quantity of switches K_{T1} are the same as a quantity of transmitters TX included in the port physical layer 06, or may be the same as a quantity of cables for data transmission in the transmission line 103. For example, when the port physical layer 06 includes four transmitters TX, there are four cables for signal transmission in the transmission line 103, and the interface circuit 10 may include four capacitors C_{T1}, four resistors R_{T1}, and four switches K_{T1}. One transmitter TX, one capacitor C_{T1}, one resistor R_{T1}, and one switch K_{T1} form one signal transmission channel. Therefore, the device 101 may include a plurality of signal transmission channels, and components included in each signal transmission channel and a connection relationship among the components are the same. The following describes a connection relationship among components by using one of the signal transmission channels as an example. Specifically, one end of a capacitor C_{T1} is coupled to an output end of a transmitter TX, the other end of the capacitor C_{T1} and one end of a resistor R_{T1} are coupled to the connection end A111 in the interface A11, and the other end of the resistor R_{T1} is coupled to the common ground Gnd through a switch K_{T1}. It should be noted that the plurality of capacitors C_{T1}, the plurality of resistors R_{T1}, and the plurality of switches K_{T1} in this embodiment of this application may be provided outside the interface chip shown in FIG. 3. Based on the circuit structure shown in FIG. 12, after the adapter plug C11 of the transmission line 103 is inserted into the interface A11, assuming that the mode controller 05 determines, based on a signal indicated by the indicator Z, that an interface of the peer device 102 is an interface (such as a DP, a USB3 interface, a USB4 interface, or a new interface) that supports an alternating-current signal coupling mode, based on a specification for the alternating-current signal coupling mode in an interface protocol, a signal transmit end needs to be provided with a coupling capacitor C_{T1} but without a resistor R_{T1}. In this case, the mode controller 05 can control the plurality of switches K_{T1} to be all turned off, as shown in FIG. 13. Based on the circuit structure shown in FIG. 12, after the adapter plug C11 of the transmission line 103 is inserted into the interface A11, assuming that the mode controller 05 determines, based on a signal indicated by the indicator Z, that an interface of the peer device 102 is an interface (such as an HDMI or a new interface) that supports a direct-current signal coupling mode, based on a specification for the direct-current signal coupling mode in an interface protocol, a signal transmit end needs to provide a voltage of a voltage value. To satisfy a specification for an alternating-current signal coupling mode in an interface protocol, a capacitor C_{T1} is provided at the signal transmit end. The capacitor C_{T1} has a function of passing through an alternating current and isolating a direct current. In this case, the capacitor C_{T1} in the interface circuit 10 isolates a direct-current signal outputted by a transmitter TX. In this case, the mode controller 05 can control the plurality of switches K_{T1} to be turned on, so that the resistor R_{T1} is coupled between the common ground Gnd and a receiver RX of the peer device 102, as shown in FIG. 14. In addition, based on the specification for the direct-current signal coupling mode in the interface protocol, a pull-up resistor R_{R1} is provided at an input end of the receiver RX of the device 102. Therefore, the resistor R_{T1} is configured to divide a voltage inputted by a power supply end of the pull-up resistor R_{R1}. By adjusting a resistance value of the resistor R_{T1}, the signal transmission interface can output a direct-current voltage specified in the interface protocol.

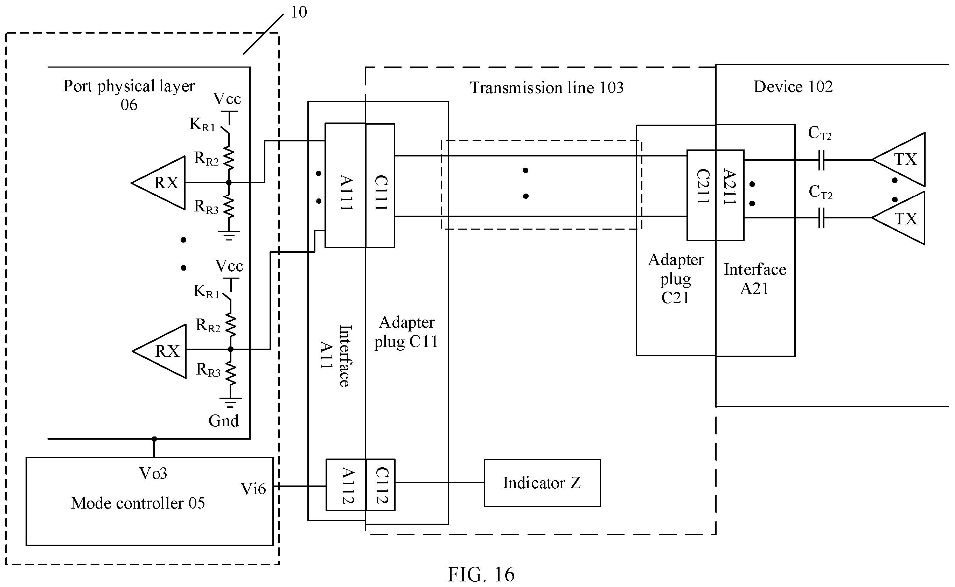

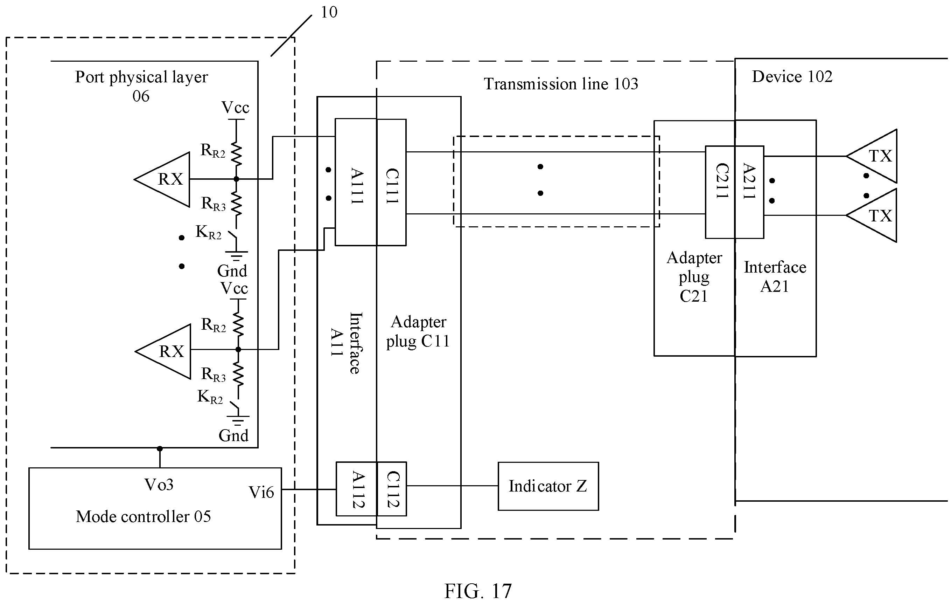

Refer to FIG. 15. FIG. 15 is a schematic diagram of a structure of an interface circuit when the multi-protocol interface A11 is used as a signal receive end. In FIG. 15, the interface circuit 10 further includes a plurality of switches K_{R1}, a plurality of switches K_{R2}, a plurality of resistors R_{R2}, and a plurality of resistors R_{R3}. A quantity of switches K_{R1}, a quantity of switches K_{R2}, a quantity of resistors R_{R2}, and a quantity of resistors R_{R3} are the same as a quantity of receivers RX included in the port physical layer 06, or may be the same as a quantity of cables for data transmission in the transmission line 103. For example, when the port physical layer 06 includes four receivers RX, there are four cables for signal transmission in the transmission line 103, and the interface circuit 10 may include four switches K_{R1}, four switches K_{R2}, four resistors R_{R2}, and four resistors R_{R3}. One transmitter RX, one switch K_{R1}, one switch K_{R2}, one resistor R_{R2}, and one resistor R_{R3} may form one signal receiving channel. Therefore, the device 101 may include a plurality of signal receiving channels, and components included in each signal receiving channel and a connection relationship among the components are the same. The following describes a connection relationship among components by using one of the signal receiving channels as an example. Specifically, both one end of a resistor R_{R2} and one end of a resistor R_{R3} are coupled to an input end of a receiver RX, the other end of the resistor R_{R2} is coupled to the power supply end Vcc through a switch K_{R1}, and the other end of the resistor R_{R3} is coupled to the common ground Gnd through a switch K_{R2}. That is, the resistor R_{R2} is a pull-up resistor, and the resistor R_{R3} is a pull-down resistor. Optionally, the plurality of switches K_{R1}, the plurality of switches K_{R2}, the plurality of resistors R_{R2}, and the plurality of resistors R_{R3} in this embodiment of this application may be integrated into the interface chip shown in FIG. 3. Based on a specification for an alternating-current signal coupling mode in an interface protocol, a signal receive end needs to be provided with a pull-down resistor R_{R3} but without a pull-up resistor R_{R2}. Based on a specification for a direct-current signal coupling mode in an interface protocol, a signal receive end needs to be provided with a pull-up resistor R_{R2} but without a pull-down resistor R_{R3}. Based on this, in this embodiment of this application, when the multi-protocol interface is used as a signal receiving interface, to enable the multi-protocol interface to satisfy the specifications for both the alternating-current signal coupling mode and the direct-current signal coupling mode in the interface protocols, both the pull-up resistor R_{R2} and the pull-down resistor R_{R3} are integrated into the interface circuit 10. The switch K_{R1} controls on-off states between the pull-up resistor R_{R2} and the power supply end Vcc, and the switch K_{R2} controls on-off states between the pull-down resistor R_{R3} and the common ground Gnd, thereby implementing multi-protocol signal transmission. The following provides a more detailed description by using specific embodiments. Based on the circuit structure shown in FIG. 15, after the adapter plug C11 of the transmission line 103 is inserted into the interface A11, assuming that the mode controller 05 determines, based on a signal indicated by the indicator Z, that an interface of the peer device 102 is an interface (such as a DP, a USB3 interface, a USB4 interface, or a future new interface) that supports an alternating-current signal coupling mode, based on a specification for the alternating-current signal coupling mode in an interface protocol, a signal receive end needs to be provided with a pull-down resistor R_{R3} but without a pull-up resistor R_{R2}. In this case, the mode controller 05 can control the plurality of switches K_{R1} to be all turned off and control the plurality of switches K_{R2} to be all turned on, as shown in FIG. 16. Based on the circuit structure shown in FIG. 15, after the adapter plug C11 of the transmission line 103 is inserted into the interface A11, assuming that the mode controller 05 determines, based on a signal indicated by the indicator Z, that an interface of the peer device 102 is an interface (such as an HDMI or a future new interface) that supports a direct-current signal coupling mode, based on a specification for the direct-current signal coupling mode in an interface protocol, a signal receive end needs to be provided with a pull-up resistor R_{R2} but without a pull-down resistor R_{R3}. In this case, the mode controller 05 can control the plurality of switches K_{R2} to be all turned off and control the plurality of switches K_{R1} to be all turned on, as shown in FIG. 17.

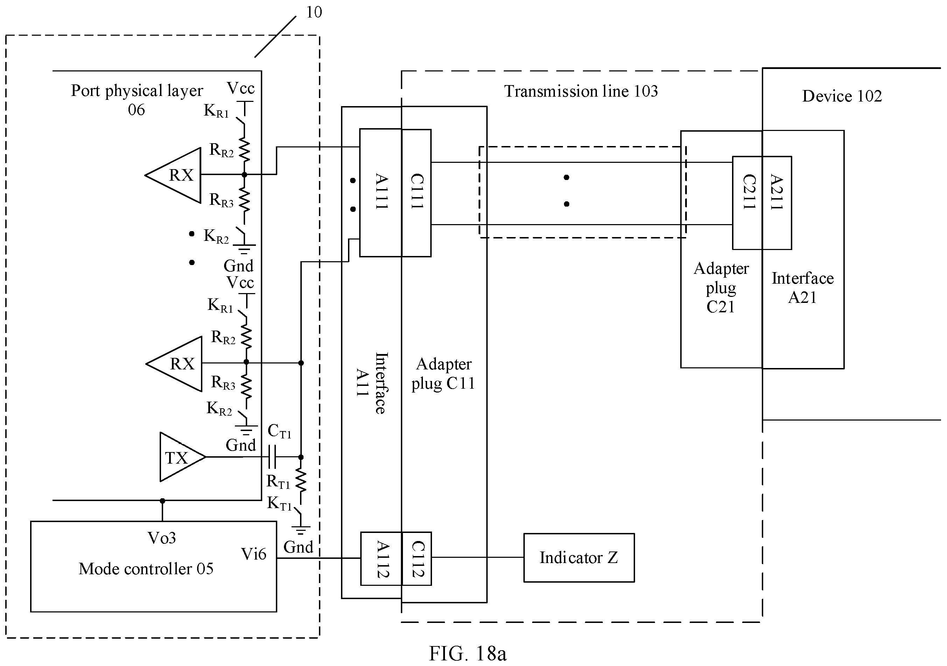

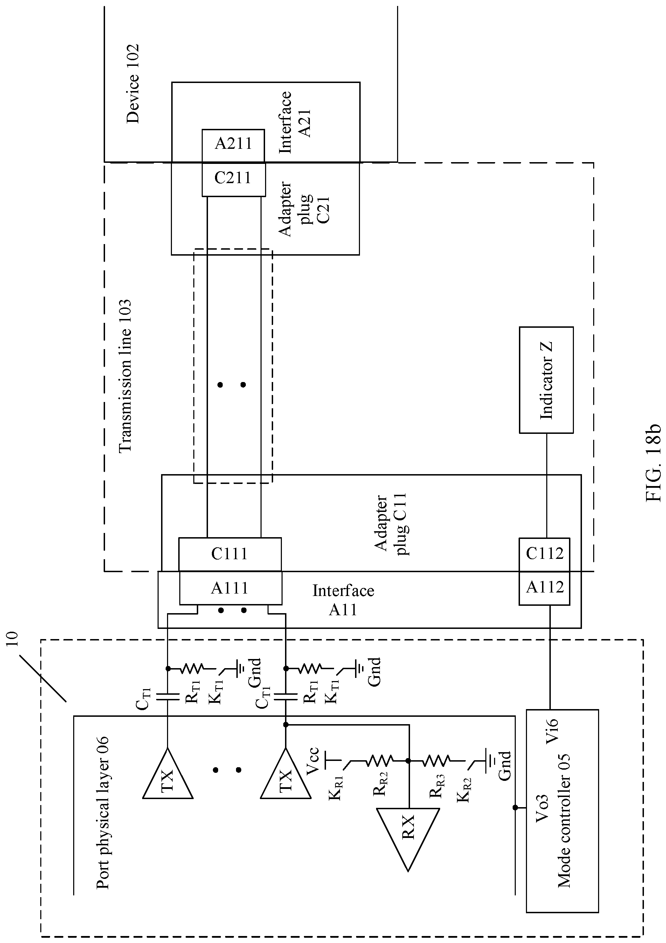

The implementations shown in FIG. 12 to FIG. 14 schematically show cases in which the interface A11 is used as a signal transmission interface. The implementations shown in FIG. 15 to FIG. 17 schematically show cases in which the interface A11 is used as a signal receiving interface. In another scenario, based on a specification in an interface protocol, the interface A11 may be a signal transceiver interface that can transmit and receive a signal in a time division manner. For example, when the interface A11 transmits a signal based on a DP protocol, in a communication cycle, the interface A11 is only configured to transmit a signal or is only configured to receive a signal. When the interface A11 transmits a signal based on a USB interface protocol, in a communication cycle, the interface A11 is configured to transmit a signal in a first time period, and is configured to receive a signal in a second time period. To enable the interface A11 to transmit and receive a signal in a communication cycle, the interface A11 may be in a structure shown in FIG. 18a or FIG. 18b.

In FIG. 18a, in addition to a transmitter TX, the port physical layer 06 is also provided with some receivers RX. A peripheral circuit of the transmitter TX and a connection relationship with other components are the same as the peripheral circuit of the transmitter TX and the connection relationship with other components shown in FIG. 12. Details are not described herein again. A peripheral circuit of the receiver RX and a connection relationship with other components are the same as the peripheral circuit of the receiver RX and the connection relationship with other components shown in FIG. 15. Details are not described herein again. Based on the structure shown in FIG. 18a, in a possible scenario, four cables may be provided in the transmission line 103. In this case, four transmitters TX and two receivers RX can be provided in the port physical layer 06. Two of the cables are coupled only to two transmitters TX in the port physical layer 06, and the other two cables are coupled to the other two transmitters TX and the two receivers RX. When the interface A21 of the device 102 is a DP interface or an HDMI interface, four transmitters TX in the port physical layer 06 are enabled, and the interface circuit 10 transmits a signal to the device 102 through the interface A11 and the transmission line 103. When the interface A21 of the device 102 is a USB interface, two transmitters TX and two receivers RX in the port physical layer 06 are enabled, and the enabled two transmitters TX and two receivers RX are coupled to different cables. In a first time period, a transmitter TX in the interface circuit 10 transmits a signal to the device 102 through the interface A11 and two cables in the transmission line 103 (or a receiver RX in the interface circuit 10 receives a signal from the device 102 through the interface A11 and two cables in the transmission line 103). In a second time period, a receiver RX in the interface circuit 10 receives a signal from the device 102 through the interface A11 and two cables in the transmission line 103 (or a transmitter TX in the interface circuit 10 transmits a signal to the device 102 through the interface A11 and two cables in the transmission line 103).

In FIG. 18b, in addition to a receiver RX, the port physical layer 06 is also provided with some transmitters TX. A peripheral circuit of the receiver RX and a connection relationship with other components are the same as the peripheral circuit of the receiver RX and the connection relationship with other components shown in FIG. 15. Details are not described herein again. A peripheral circuit of the transmitter TX and a connection relationship with other components are the same as the peripheral circuit of the transmitter TX and the connection relationship with other components shown in FIG. 12. Details are not described herein again. Based on the structure shown in FIG. 18b, in a possible scenario, four cables may be provided in the transmission line 103. In this case, four receivers RX and two transmitters TX can be provided in the port physical layer 06. Two of the cables are coupled only to two receivers RX in the port physical layer 06, and the other two cables are coupled to the other two receivers RX and the two transmitters TX. When the interface A21 of the device 102 is a DP interface or an HDMI interface, four receivers RX in the port physical layer 06 are enabled, and the interface circuit 10 receives a signal from the device 102 through the interface A11 and the transmission line 103. When the interface A21 of the device 102 is a USB interface, two transmitters TX and two receivers RX in the port physical layer 06 are enabled, and the enabled two transmitters TX and two receivers RX are coupled to different cables. In a first time period, a transmitter TX in the interface circuit 10 transmits a signal to the device 102 through the interface A11 and two cables in the transmission line 103 (or a receiver RX in the interface circuit 10 receives a signal from the device 102 through the interface A11 and two cables in the transmission line 103). In a second time period, a receiver RX in the interface circuit 10 receives a signal from the device 102 through the interface A11 and two cables in the transmission line 103 (or a transmitter TX in the interface circuit 10 transmits a signal to the device 102 through the interface A11 and two cables in the transmission line 103).

The system architecture shown in FIG. 1 schematically shows that the device 101 includes an interface A11. When the device 101 needs to transmit a signal to another device and receive a signal from another device, a plurality of interfaces may be provided in the device 101. Some interfaces are configured to transmit a signal to another device, and the other interfaces are configured to receive a signal from another device, as shown in FIG. 18. FIG. 18 schematically shows a case in which the device 101 includes an interface A12, an interface A13, an interface A14, and an interface A15. The interface A12 is coupled to an interface circuit 10A. The interface A13 is coupled to an interface circuit 10B. The interface A14 is coupled to an interface circuit 10C. The interface A15 is coupled to an interface circuit 10D. The interface A12, the interface A13, the interface A14, and the interface A15 may be all multi-protocol interfaces. The interface A12 and the interface A13 may be signal transmission interfaces. The interface A14 and the interface A15 may be signal receiving interfaces. In this case, port physical layers 06 in the interface circuit 10A and the interface circuit 10B include transmitters TX, and port physical layers 06 in the interface circuit 10C and the interface circuit 10D include receivers RX. The signal transmission interface herein refers to an interface that is only configured to transmit a signal in a communication cycle based on an HDMI protocol or a DP protocol. The signal receiving interface herein refers to an interface that is only configured to receive a signal in a communication cycle based on an HDMI protocol or a DP protocol. Certainly, in another possible implementation, some receivers TX may be provided in the port physical layers 06 of the interface circuit 10A and the interface circuit 10B, to satisfy a requirement of a USB interface protocol. Similarly, some transmitters RX may be provided in the port physical layers 06 of the interface circuit 10C and the interface circuit 10D, to satisfy a requirement of the USB interface protocol. Structures of the interface circuit 10A and the interface circuit 10B, and a coupling relationship between each interface and a corresponding interface circuit are the same as the interface circuit 10 and the coupling relationship between the interface circuit 10 and the interface A11 that are described in any embodiment of FIG. 2 to FIG. 14, and FIG. 18a, and details are not described herein again. Structures of the interface circuit 10C and the interface circuit 10D, and a coupling relationship between each interface and a corresponding interface circuit are the same as the interface circuit 10 and the coupling relationship between the interface circuit 10 and the interface A11 that are described in any embodiment of FIG. 2 to FIG. 11, FIG. 15 to FIG. 17, and FIG. 18b, and details are not described herein again.

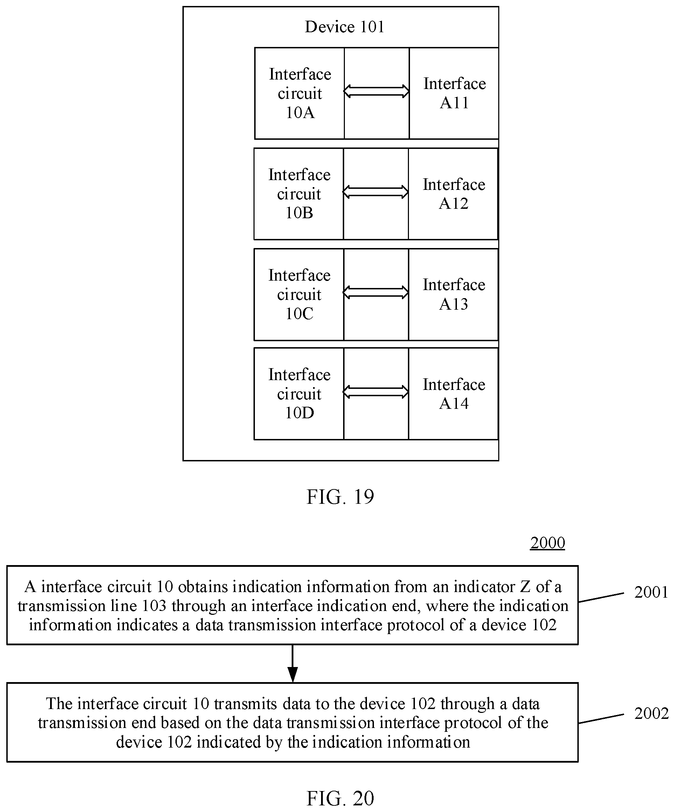

Based on a same inventive concept, an embodiment of this application further provides a data transmission method. The data transmission method is applied to the data transmission system shown in FIG. 1. FIG. 19 shows a procedure 2000 of the data transmission method according to this embodiment of this application. The procedure 2000 of the data transmission method includes the following steps.

Step 2001: An interface circuit 10 obtains indication information from an indicator Z of a transmission line 103 through an interface indication end, where the indication information indicates a data transmission interface protocol of a device 102.

Step 2002: The interface circuit 10 transmits data to the device 102 through a data transmission end based on the data transmission interface protocol of the device 102 indicated by the indication information.

In a possible implementation, the interface circuit 10 includes the plurality of interface controllers, the multiplexer 07, the port physical layer 06, and the mode controller 05 that are shown in FIG. 2. The step 2002 further includes the following steps: The mode controller 05 controls, based on the indication information, the multiplexer 07 to connect one of the plurality of interface controllers to the port physical layer 06. The interface controller connected to the port physical layer 06 has a same data transmission interface protocol as the device 102. The interface controller connected to the port physical layer 06 controls the port physical layer 06 to transmit data to the device 102 through the data transmission end of the interface circuit based on the data transmission protocol the same as that of the device 102.

In a possible implementation, the data transmission method further includes the following step: The mode controller 05 adjusts, based on the indication information, at least one of the following parameters of a transmitter and a receiver in the port physical layer 06: a signal transmission rate or an amplitude of a transmitted signal.

In a possible implementation, the interface circuit includes the plurality of interface controllers, the plurality of port physical layers, the switch group SW, and the mode controller 05 that are shown in FIG. 9. The plurality of interface controllers, the plurality of port physical layers, and a plurality of switches in the switch group SW are coupled in a one-to-one correspondence. The step 2002 further includes the following steps: The mode controller 05 controls, based on the indication information, one switch in the switch group SW to be turned on. An interface controller corresponding to the turned-on switch controls a port physical layer coupled to the turned-on switch to transmit data to the device 102 through the data transmission end of the interface circuit based on the data transmission protocol the same as that of the device 102.

In a possible implementation, the indicator is a resistor, and the indication information of the indicator is an analog signal.

In a possible implementation, the indicator is a register, and the indication information of the indicator is a digital signal.

In a possible implementation, before the interface circuit 10 transmits data to the device 102, the data transmission method further includes the following step: The interface circuit 10 establishes a connection to the device 102 in a direct-current coupling mode or an alternating-current coupling mode.

## Claims

1. An interface circuit (10), wherein the interface circuit (10) is configured to perform data transmission with a first device (102) not comprised in the interface circuit (10) by using a data transmission apparatus not comprised in the interface circuit (10), and the interface circuit (10) comprises an interface indication end (J2) and a data transmission end (J1);
the interface circuit (10) is configured to obtain indication information from an indicator (Z) of the data transmission apparatus through the interface indication end (J2), wherein the indication information is configured to indicate a data transmission interface protocol of the first device (102);
the interface circuit (10) is configured to transmit data to the first device (102) through the data transmission end (J1) based on the data transmission interface protocol of the first device (102) indicated by the indication information;
the interface circuit (10) further comprises a plurality of interface controllers (01, 02, 03, 04), a multiplexer (07), a port physical layer (06), and a mode controller (05), wherein
the plurality of interface controllers (01, 02, 03, 04) are respectively coupled to a plurality of input ends of the multiplexer (07);
an output end (Vo1) of the multiplexer (07) is coupled to a first end (Vi5) of the port physical layer (06);
a second end (Vi5) of the port physical layer (06) is coupled to the data transmission end (J1) of the interface circuit (10);
an input end (Vi6) of the mode controller (05) is coupled to the interface indication end (J2) of the interface circuit (10), an output end (Vo3) of the mode controller (05) is coupled to a first control end (Vc1) of the multiplexer (07), and the mode controller (05) is configured to control, based on the indication information, the multiplexer (07) to connect a first interface controller (01, 02, 03, 04) in the plurality of interface controllers (01, 02, 03, 04) to the port physical layer (06), and the output end (Vo3) of the mode controller (05) is also coupled to a first control end (Vc2) of the port physical layer (06);
the port physical layer (06) comprises a transmitter (TX), and the transmitter (TX) is configured to transmit data to the first device (102) by using the data transmission apparatus;
the interface circuit (10) further comprises a capacitor (C_{T1}), a second resistor (R_{T1}), and a first switch (K_{T1}), wherein
a first end of the capacitor (C_{T1}) is coupled to an output end of the transmitter (TX), and a second end of the capacitor (C_{T1}) and one end of the second resistor (R_{T1}) are coupled to the data transmission end (J1) of the interface circuit (10); and
the other end of the second resistor (R_{T1}) is coupled to the ground end through the first switch (K_{T1}).

2. The interface circuit (10) according to claim 1, wherein the output end (Vo3) of the mode controller (05) is further coupled to a second control end (Vc) of the port physical layer (06); and the mode controller (05) is further configured to:
adjust, based on the indication information, at least one of the following parameters of a transmitter (TX) and a receiver (RX) in the port physical layer (06): a signal transmission rate or an amplitude of a transmitted signal.

3. The interface circuit (10) according to claim 1 or 2, wherein the mode controller (05) comprises a comparator (B) and a first resistor (R2), wherein
a first input end of the comparator (B) is coupled to a ground end, a second input end of the comparator (B) is coupled to the input end (Vi6) of the mode controller (05), and an output end of the comparator (B) is coupled to the output end (Vo3) of the mode controller (05); and
one end of the first resistor (R2) is coupled to a power supply end (Vcc), and the other end of the first resistor (R2) is coupled to the second input end of the comparator (B).

4. The interface circuit (10) according to claim 1 or 2, wherein the mode controller (05) comprises a comparator (B) and a current source, wherein
a first input end of the comparator (B) is coupled to a ground end, a second input end of the comparator (B) is coupled to the input end (Vi6) of the mode controller (05), and an output end of the comparator (B) is coupled to the output end (Vo3) of the mode controller (05); and
one end of the current source (I) is coupled to a power supply end (Vcc), and the other end of the current source (I) is coupled to the second input end of the comparator (B).

5. The interface circuit (10) according to claim 1 or 2, wherein the indication information is an analog signal, and the mode controller (05) comprises an analog-to-digital converter and a first resistor (R2), wherein
one end of the first resistor (R2) is coupled to a power supply end (Vcc), and the other end of the first resistor (R2) is coupled to an input end of the analog-to-digital converter; and
a first input end of the analog-to-digital converter is coupled to a ground end, a second input end of the analog-to-digital converter is coupled to the input end (Vi6) of the mode controller (05), and the analog-to-digital converter generates a digital signal based on the indication information and provides the digital signal to the output end (Vo3) of the mode controller (05).

6. The interface circuit (10) according to claim 1or 2, wherein the indication information is an analog signal, and the mode controller (05) comprises an analog-to-digital converter and a current source (I), wherein
one end of the current source (I) is coupled to a power supply end (Vcc), and the other end of the current source (I) is coupled to an input end of the analog-to-digital converter; and
a first input end of the analog-to-digital converter is coupled to a ground end, a second input end of the analog-to-digital converter is coupled to the input end (Vi6) of the mode controller (05), and the analog-to-digital converter generates a digital signal based on the indication information and provides the digital signal to the output end (Vo3) of the mode controller (05).

7. The interface circuit (10) according to claim 1 or 2, wherein the indication information is a digital signal, and the mode controller (05) comprises a reader, wherein
the reader is configured to read the indication information, generate a control signal based on the indication information, and provide the control signal to the input end (Vi6) of the mode controller (05).

8. The interface circuit (10) according to any one of claims 1 to 7, wherein the port physical layer (06) further comprises a receiver (RX), and the receiver (RX) is configured to receive data from the first device (102) by using the data transmission apparatus; and
the interface circuit (10) further comprises a third resistor (R_{R2}), a second switch (K_{R1}), a fourth resistor (R_{R3}), and a third switch (K_{R2}), wherein
a first end of the third resistor (R_{R2}) is coupled to the power supply end (Vcc) through the second switch (K_{R1});
a second end of the third resistor (R_{R2}), a first end of the fourth resistor (R_{R3}), and a receive end of the receiver (RX) are all coupled to the data transmission end (J1) of the interface circuit (10); and
a second end of the fourth resistor (R_{R3}) is coupled to the ground end through the third switch (KR2).

9. An electronic device, wherein the electronic device comprises:
a physical interface; and
the interface circuit (10) according to any one of claims 1 to 8, wherein
the interface circuit (10) is coupled to a data transmission end (J1) and the indicator (Z) that are in the data transmission apparatus through the physical interface.

10. The electronic device according to claim 9, wherein the physical interface comprises a first connection end (A111) and a second connection end (A112);
the data transmission end (J1) of the interface circuit (10) is coupled to the first connection end (A111); and
the interface indication end (J2) of the interface circuit (10) is coupled to the second connection end (A112).

11. A system comprising the interface circuit (10) according to claim 1 and a data transmission apparatus, wherein the data transmission apparatus is coupled between a first device (101) not comprised in the data transmission apparatus and a second device (102) not comprised in the data transmission apparatus and is configured to transmit data between the first device (101) and the second device (102), and the data transmission apparatus comprises:
an indicator (Z), coupled to the interface circuit (10) in the second device (101) and configured to provide indication information to the interface circuit (10), wherein the indication information indicates a data transmission interface protocol of the first device (102).

12. The data transmission apparatus according to claim 11, wherein the data transmission apparatus further comprises:
a plurality of cables (C), wherein the plurality of cables (C) is configured to couple the first device (101) to the second device (102), so that data is transmitted between the first device (101) and the second device (102) through the plurality of cables (C).

13. The data transmission apparatus according to claim 12, wherein the data transmission apparatus further comprises a first adapter plug (C11) coupled to the first device (101) and a second adapter plug coupled (C21) to the second device (102), wherein
the first adapter plug (C11) comprises a first data transmission end (C111) and an interface indication end (C112), a first end of each of the plurality of cables (C) is coupled to the first data transmission end (C111), and the indicator (Z) is coupled to the interface indication end (C112); and
the second adapter plug (C21) comprises a second data transmission end (C211), and a second end of each of the plurality of cables (C) is coupled to the second data transmission end (C211).

14. The data transmission apparatus according to any one of claims 11 to 13, wherein the indication information is an analog signal, the indicator (Z) comprises a fifth resistor (R1), one end of the fifth resistor (R1) is coupled to the interface indication end (C112) of the first adapter plug (C11), and the other end of the fifth resistor (R1) is coupled to a ground end.

15. The data transmission apparatus according to any one of claims 11 to 13, wherein the indication information is a digital signal, and the indicator (Z) comprises a register, wherein
the register is configured to store data, and the data indicates a protocol type of a data transmission interface in the second device (101).

## Patentansprüche

1. Schnittstellenschaltung (10), wobei die Schnittstellenschaltung (10) konfiguriert ist, eine Datenübertragung mit einer ersten Vorrichtung (102), die nicht in der Schnittstellenschaltung (10) enthalten ist, durch Verwenden einer Datenübertragungsvorrichtung, die nicht in der Schnittstellenschaltung (10) enthalten ist, auszuführen, und die Schnittstellenschaltung (10) ein Schnittstellenangabeende (J2) und ein Datenübertragungsende (J1) umfasst;
wobei die Schnittstellenschaltung (10) konfiguriert ist, Angabeinformationen von einem Indikator (Z) der Datenübertragungsvorrichtung durch das Schnittstellenangabeende (J2) zu erhalten, wobei die Angabeinformationen konfiguriert sind, ein Datenübertragungsschnittstellenprotokoll der ersten Vorrichtung (102) anzugeben;
die Schnittstellenschaltung (10) konfiguriert ist, Daten an die erste Vorrichtung (102) durch das Datenübertragungsende (J1) anhand des Datenübertragungsschnittstellenprotokolls der ersten Vorrichtung (102), das durch die Angabeinformationen angegeben wird, zu senden;
die Schnittstellenschaltung (10) ferner mehrere Schnittstellensteuereinheiten (01, 02, 03, 04), einen Multiplexer (07), eine physikalische Schicht eines Anschlusses (06) und eine Betriebsartsteuereinheit (05) umfasst, wobei
die mehreren Schnittstellensteuereinheiten (01, 02, 03, 04) jeweils an mehrere Eingangsenden des Multiplexers (07) gekoppelt sind;
ein Ausgangsende (Vo1) des Multiplexers (07) an ein erstes Ende (Vi5) der physikalischen Schicht des Anschlusses (06) gekoppelt ist;
ein zweites Ende (Vi5) der physikalischen Schicht des Anschlusses (06) an das Datenübertragungsende (J1) der Schnittstellenschaltung (10) gekoppelt ist;
ein Eingangsende (Vi6) der Betriebsartsteuereinheit (05) an das Schnittstellenangabeende (J2) der Schnittstellenschaltung (10) gekoppelt ist, ein Ausgangsende (Vo3) der Betriebsartsteuereinheit (05) an ein erstes Steuerende (Vc1) des Multiplexers (07) gekoppelt ist und die Betriebsartsteuereinheit (05) konfiguriert ist, anhand der Angabeinformationen den Multiplexer (07) zu steuern, eine erste Schnittstellensteuereinheit (01, 02, 03, 04) in den mehreren Schnittstellensteuereinheiten (01, 02, 03, 04) an die physikalische Schicht des Anschlusses (06) zu koppeln, und das Ausgangsende (Vo3) der Betriebsartsteuereinheit (05) auch an ein erstes Steuerende (Vc2) der physikalischen Schicht des Anschlusses (06) gekoppelt ist;
wobei die physikalische Schicht des Anschlusses (06) einen Sender (TX) umfasst und der Sender (TX) konfiguriert ist, Daten an die erste Vorrichtung (102) durch Verwenden der Datenübertragungsvorrichtung zu senden;
die Schnittstellenschaltung (10) ferner einen Kondensator (C_{TI}), einen zweiten Widerstand (R_{T1}) und einen ersten Schalter (K_{TI}) umfasst, wobei
ein erstes Ende des Kondensators (C_{TI}) an ein Ausgangsende des Senders (TX) gekoppelt ist und ein zweites Ende des Kondensators (C_{TI}) und ein Ende des zweiten Widerstands (R_{TI}) an das Datenübertragungsende (J1) der Schnittstellenschaltung (10) gekoppelt sind; und
das andere Ende des zweiten Widerstands (R_{TI}) durch den ersten Schalter (K_{TI}) an das Erdungsende gekoppelt ist.

2. Schnittstellenschaltung (10) nach Anspruch 1, wobei das Ausgangsende (Vo3) der Betriebsartsteuereinheit (05) ferner an ein zweites Steuerende (Vc) der physikalischen Schicht des Anschlusses (06) gekoppelt ist; und die Betriebsartsteuereinheit (05) ferner konfiguriert ist zum:
Anpassen anhand der Angabeinformationen mindestens eines der folgenden Parameter eines Senders (TX) und eines Empfängers (RX) in der physikalischen Schicht des Anschlusses (06): einer Signalübertragungsrate oder einer Amplitude eines gesendeten Signals.

3. Schnittstellenschaltung (10) nach Anspruch 1 oder 2, wobei die Betriebsartsteuereinheit (05) einen Komparator (B) und einen ersten Widerstand (R2) umfasst, wobei
ein erstes Eingangssende des Komparators (B) an ein Erdungsende gekoppelt ist, ein zweites Eingangsende des Komparators (B) an das Eingangsende (Vi6) der Betriebsartsteuereinheit (05) gekoppelt ist und ein Ausgangsende des Komparators (B) an das Ausgangsende (Vo3) der Betriebsartsteuereinheit (05) gekoppelt ist; und
ein Ende des ersten Widerstands (R2) an ein Stromversorgungsende (Vcc) gekoppelt ist und das andere Ende des ersten Widerstands (R2) an das zweite Eingangsende des Komparators (B) gekoppelt ist.

4. Schnittstellenschaltung (10) nach Anspruch 1 oder 2, wobei die Betriebsartsteuereinheit (05) einen Komparator (B) und eine Stromquelle umfasst, wobei
ein erstes Eingangsende des Komparators (B) an ein Erdungsende gekoppelt ist, ein zweites Eingangsende des Komparators (B) an das Eingangsende (Vi6) der Betriebsartsteuereinheit (05) gekoppelt ist und ein Ausgangsende des Komparators (B) an das Ausgangsende (Vo3) der Betriebsartsteuereinheit (05) gekoppelt ist; und
ein Ende der Stromquelle (I) an ein Stromversorgungsende (Vcc) gekoppelt ist und das andere Ende der Stromquelle (I) an das zweite Eingangsende des Komparators (B) gekoppelt ist.

5. Schnittstellenschaltung (10) nach Anspruch 1 oder 2, wobei die Angabeinformationen ein Analogsignal sind und die Betriebsartsteuereinheit (05) einen Analog-/DigitalWandler und einen ersten Widerstand (R2) umfasst, wobei
ein Ende des ersten Widerstands (R2) an ein Stromversorgungsende (Vcc) gekoppelt ist und das andere Ende des ersten Widerstands (R2) an ein Eingangsende des Analog-/Digital-Wandlers gekoppelt ist; und
ein erstes Eingangsende des Analog-/Digital-Wandlers an ein Erdungsende gekoppelt ist, ein zweites Eingangsende des Analog-/Digital-Wandlers an das Eingangsende (Vi6) der Betriebsartsteuereinheit (05) gekoppelt ist und der Analog-/Digital-Wandler ein Digitalsignal anhand der Angabeinformationen erzeugt und das Digitalsignal an das Ausgangsende (Vo3) der Betriebsartsteuereinheit (05) liefert.

6. Schnittstellenschaltung (10) nach Anspruch 1 oder 2, wobei die Angabeinformationen ein Analogsignal sind und die Betriebsartsteuereinheit (05) einen Analog-/DigitalWandler und eine Stromquelle (I) umfasst, wobei
ein Ende der Stromquelle (I) an ein Stromversorgungsende (Vcc) gekoppelt ist und das andere Ende der Stromquelle (I) an ein Eingangsende des Analog-/Digital-Wandlers gekoppelt ist; und
ein erstes Eingangsende des Analog-/Digital-Wandlers an ein Erdungsende gekoppelt ist, ein zweites Eingangsende des Analog-/Digital-Wandlers an das Eingangsende (Vi6) der Betriebsartsteuereinheit (05) gekoppelt ist und der Analog-/Digital-Wandler ein Digitalsignal anhand der Angabeinformationen erzeugt und das Digitalsignal an das Ausgangsende (Vo3) der Betriebsartsteuereinheit (05) liefert.

7. Schnittstellenschaltung (10) nach Anspruch 1 oder 2, wobei die Angabeinformationen ein Digitalsignal sind und die Betriebsartsteuereinheit (05) ein Lesegerät umfasst, wobei
das Lesegerät konfiguriert ist, die Angabeinformationen zu lesen, ein Steuersignal anhand der Angabeinformationen zu erzeugen und das Steuersignal an das Eingangsende (Vi6) der Betriebsartsteuereinheit (05) zu liefern.

8. Schnittstellensteuerschaltung (10) nach einem der Ansprüche 1 bis 7, wobei die physikalische Schicht des Anschlusses (06) ferner einen Empfänger (RX) umfasst und der Empfänger (RX) konfiguriert ist, Daten von der ersten Vorrichtung (102) durch Verwenden der Datenübertragungsvorrichtung zu empfangen; und
die Schnittstellenschaltung (10) ferner einen dritten Widerstand (R_{R2}), einen zweiten Schalter (K_{R1}), einen vierten Widerstand (R_{R3}) und einen dritten Schalter (K_{R2}) umfasst, wobei
ein erstes Ende des dritten Widerstands (R_{R2}) an das Stromversorgungsende (Vcc) durch den zweiten Schalter (K_{R1}) gekoppelt ist;
ein zweites Ende des dritten Widerstands (R_{R2}), ein erstes Ende des vierten Widerstands (R_{R3}) und ein Empfangsende des Empfängers (RX) alle an das Datenübertragungsende (J1) der Schnittstellenschaltung (10) gekoppelt sind; und
ein zweites Ende des vierten Widerstands (R_{R3}) an das Erdungsende durch den dritten Schalter (K_{R2}) gekoppelt ist.

9. Elektronische Vorrichtung, wobei die elektronische Vorrichtung Folgendes umfasst:
eine physikalische Schnittstelle; und
die Schnittstellenschaltung (10) nach einem der Ansprüche 1 bis 8, wobei
die Schnittstellenschaltung (10) an ein Datenübertragungsende (J1) und den Indikator (Z), die in der Datenübertragungsvorrichtung sind, durch die physikalische Schnittstelle gekoppelt ist.

10. Elektronische Vorrichtung nach Anspruch 9, wobei die physikalische Schnittstelle ein erstes Verbindungsende (A111) und ein zweites Verbindungsende (A112) umfasst;
das Datenübertragungsende (J1) der Schnittstellenschaltung (10) an das erste Verbindungsende (A111) gekoppelt ist; und
das Schnittstellenangabeende (J2) der Schnittstellenschaltung (10) an das zweite Verbindungsende (A112) gekoppelt ist.

11. System, das die Schnittstellenschaltung (10) nach Anspruch 1 und eine Datenübertragungsvorrichtung umfasst, wobei die Datenübertragungsvorrichtung zwischen eine erste Vorrichtung (101), die nicht in der Datenübertragungsvorrichtung enthalten ist, und eine zweite Vorrichtung (102), die nicht in der Datenübertragungsvorrichtung enthalten ist, gekoppelt ist und konfiguriert ist, Daten zwischen der ersten Vorrichtung (101) und der zweiten Vorrichtung (102) zu übertragen, und die Datenübertragungsvorrichtung Folgendes umfasst:
einen Indikator (Z), der an die Schnittstellenschaltung (10) in der zweiten Vorrichtung (101) gekoppelt ist und konfiguriert ist, Angabeinformationen an die Schnittstellenschaltung (10) zu liefern, wobei die Angabeinformationen ein Datenübertragungsschnittstellenprotokoll der ersten Vorrichtung (102) angeben.

12. Datenübertragungsvorrichtung nach Anspruch 11, wobei die Datenübertragungsvorrichtung ferner Folgendes umfasst:
mehrere Kabel (C), wobei die mehreren Kabel (C) konfiguriert sind, die erste Vorrichtung (101) an die zweite Vorrichtung (102) zu koppeln, so dass Daten zwischen der ersten Vorrichtung (101) und der zweiten Vorrichtung (102) durch die mehreren Kabel übertragen werden.

13. Datenübertragungsvorrichtung nach Anspruch 12, wobei die Datenübertragungsvorrichtung ferner einen ersten Adapterstecker (C11), der an die erste Vorrichtung (101) gekoppelt ist, und einen zweiten Adapterstecker (C21), der an die zweite Vorrichtung (102) gekoppelt ist, umfasst, wobei
der erste Adapterstecker (C11) ein erstes Datenübertragungsende (C111) und ein Schnittstellenangabeende (C112) umfasst, wobei ein erstes Ende der mehreren Kabel (C) an das erste Datenübertragungsende (C111) gekoppelt ist und der Indikator (Z) an das Schnittstellenangabeende (C112) gekoppelt ist; und
der zweite Adapterstecker (C21) ein zweites Datenübertragungsende (C211) umfasst und ein zweites Ende jedes der mehreren Kabel (C) an das zweite Datenübertragungsende (C211) gekoppelt ist.

14. Datenübertragungsvorrichtung nach einem der Ansprüche 11 bis 13, wobei die Angabeinformationen ein Analogsignal sind, der Indikator (Z) einen fünften Widerstand (R1) umfasst, wobei ein Ende des fünften Widerstands (R1) an das Schnittstellenangabeende (C112) des ersten Adaptersteckers (C11) gekoppelt ist und das andere Ende des fünften Widerstands (R1) an ein Erdungsende gekoppelt ist.

15. Datenübertragungsvorrichtung nach einem der Ansprüche 11 bis 13, wobei die Angabeinformationen ein Digitalsignal sind und der Indikator (Z) ein Register umfasst, wobei
das Register konfiguriert ist, Daten zu speichern, und die Daten einen Protokolltyp einer Datenübertragungsschnittstelle in der zweiten Vorrichtung (101) angeben.

## Revendications

1. Circuit d'interface (10), ce circuit d'interface (10) étant configuré de façon à exécuter la transmission de données avec un premier dispositif (102) pas compris dans le circuit d'interface (10) en utilisant un appareil de transmission de données pas compris dans le circuit d'interface (10), et ce circuit d'interface (10) comportant une extrémité d'indication d'interface (J2) et une extrémité de transmission de données (J1) ;
ce circuit d'interface (10) étant configuré de façon à obtenir une information d'indication venant d'un indicateur (Z) de l'appareil de transmission de données via l'extrémité d'indication d'interface (J2), cette information d'indication étant configurée de façon à indiquer un protocole d'interface de transmission de données du premier dispositif (102) ;
ce circuit d'interface (10) étant configuré de façon à transmettre des données au premier dispositif (102) via l'extrémité de transmission de données (J1) en se basant sur le protocole d'interface de transmission de données du premier dispositif (102) indiqué par l'information d'indication ;
ce circuit d'interface (10) comportant en outre une pluralité de contrôleurs d'interface (01, 02, 03, 04), un multiplexeur (07), une couche physique de port (06) et un contrôleur de mode (05),
la pluralité de contrôleurs d'interface (01, 02, 03, 04) étant couplée respectivement à une pluralité d'extrémités d'entrée du multiplexeur (07) ;
une extrémité de sortie (Vo1) du multiplexeur (07) étant couplée à une première extrémité (Vi5) de la couche physique de port (06) ;
une deuxième extrémité (Vi5) de la couche physique de port (06) étant couplée à l'extrémité de transmission de données (J1) du circuit d'interface (10) ;
une extrémité d'entrée (Vi6) du contrôleur de mode (05) étant couplée à l'extrémité d'indication d'interface (J2) du circuit d'interface (10), une extrémité de sortie (Vo3) du contrôleur de mode (05) étant couplée à une première extrémité de commande (Vc1) du multiplexeur (07), et le contrôleur de mode (05) étant configuré de façon à commander le multiplexeur (07), en se basant sur l'information d'indication, afin de connecter un premier contrôleur d'interface (01, 02, 03, 04) parmi la pluralité de contrôleurs d'interface (01, 02, 03, 04) à la couche physique de port (06), et l'extrémité de sortie (Vo3) du contrôleur de mode (05) étant aussi couplée à une première extrémité de commande (Vc2) de la couche physique de port (06) ;
la couche physique de port (06) comportant un transmetteur (TX) et ce transmetteur (TX) étant configuré de façon à transmettre des données au premier dispositif (102) en utilisant l'appareil de transmission de données ;
le circuit d'interface (10) comportant en outre un condensateur (C_{TI}), une deuxième résistance (R_{T1}) et un premier commutateur (K_{T1}) ;
une première extrémité du condensateur (C_{T1}) étant couplée à une extrémité de sortie du transmetteur (TX), et une deuxième extrémité du condensateur (C_{T1}) et une extrémité de la deuxième résistance (R_{T1}) étant couplées à l'extrémité de transmission de données (J1) du circuit d'interface (10) ; et
l'autre extrémité de la deuxième résistance (R_{T1}) étant couplée à l'extrémité masse via le premier commutateur (K_{T1}).

2. Circuit d'interface (10) selon la revendication 1, dans lequel l'extrémité de sortie (Vo3) du contrôleur de mode (05) est couplée en outre à une deuxième extrémité de commande (Vc) de la couche physique de port (06) ; et le contrôleur de mode (05) est configuré en outre de façon à :
en se basant sur l'information d'indication, régler au moins un des paramètres suivants d'un transmetteur (TX) et d'un récepteur (RX) dans la couche physique de port (06) :
une vitesse de transmission de signal ou une amplitude d'un signal transmis.

3. Circuit d'interface (10) selon la revendication 1 ou 2, dans lequel le contrôleur de mode (05) comporte un comparateur (B) et une première résistance (R2),
une première extrémité d'entrée du comparateur (B) étant couplée à une extrémité masse, une deuxième extrémité d'entrée du comparateur (B) étant couplée à l'extrémité d'entrée (Vi6) du contrôleur de mode (05), et une extrémité de sortie du comparateur (B) étant couplée à l'extrémité de sortie (Vo3) du contrôleur de mode (05) ; et
une extrémité de la première résistance (R2) étant couplée à une extrémité d'alimentation électrique (Vcc), et l'autre extrémité de la première résistance (R2) étant couplée à la deuxième extrémité d'entrée du comparateur (B).

4. Circuit d'interface (10) selon la revendication 1 ou 2, dans lequel le contrôleur de mode (05) comporte un comparateur (B) et une source de courant,
une première extrémité d'entrée du comparateur (B) étant couplée à une extrémité masse, une deuxième extrémité d'entrée du comparateur (B) étant couplée à l'extrémité d'entrée (Vi6) du contrôleur de mode (05), et une extrémité de sortie du comparateur (B) étant couplée à l'extrémité de sortie (Vo3) du contrôleur de mode (05) ; et
une extrémité de la source de courant (I) étant couplée à une extrémité d'alimentation électrique (Vcc), et l'autre extrémité de la source de courant (I) étant couplée à la deuxième extrémité d'entrée du comparateur (B).

5. Circuit d'interface (10) selon la revendication 1 ou 2, dans lequel l'information d'indication est un signal analogique, et le contrôleur de mode (05) comporte un convertisseur analogique-numérique et une première résistance (R2),
une extrémité de la première résistance (R2) étant couplée à une extrémité d'alimentation électrique (Vcc), et l'autre extrémité de la première résistance (R2) étant couplée à une extrémité d'entrée du convertisseur analogique-numérique ; et
une première extrémité d'entrée du convertisseur analogique-numérique étant couplée à une extrémité masse, une deuxième extrémité d'entrée du convertisseur analogique-numérique étant couplée à l'extrémité d'entrée (Vi6) du contrôleur de mode (05), et le convertisseur analogique-numérique générant un signal numérique en se basant sur l'information d'indication et fournissant ce signal numérique à l'extrémité de sortie (Vo3) du contrôleur de mode (05).

6. Circuit d'interface (10) selon la revendication 1 ou 2, dans lequel l'information d'indication est un signal analogique, et le contrôleur de mode (05) comporte un convertisseur analogique-numérique et une source de courant (I),
une extrémité de la source de courant (I) étant couplée à une extrémité d'alimentation électrique (Vcc), et l'autre extrémité de la source de courant (I) étant couplée à une extrémité d'entrée du convertisseur analogique-numérique ; et
une première extrémité d'entrée du convertisseur analogique-numérique étant couplée à une extrémité masse, une deuxième extrémité d'entrée du convertisseur analogique-numérique étant couplée à l'extrémité d'entrée (Vi6) du contrôleur de mode (05), et le convertisseur analogique-numérique générant un signal numérique en se basant sur l'information d'indication et fournissant ce signal numérique à l'extrémité de sortie (Vo3) du contrôleur de mode (05).

7. Circuit d'interface (10) selon la revendication 1 ou 2, dans lequel l'information d'indication est un signal numérique, et le contrôleur de mode (05) comporte un lecteur,
ce lecteur étant configuré de façon à lire l'information d'indication, à générer un signal de commande en se basant sur l'information d'indication, et à fournir le signal de commande à l'extrémité d'entrée (Vi6) du contrôleur de mode (05).

8. Circuit d'interface (10) selon l'une quelconque des revendications 1 à 7, dans lequel la couche physique de port (06) comporte en outre un récepteur (RX), et ce récepteur (RX) est configuré de façon à recevoir des données venant du premier dispositif (102) en utilisant l'appareil de transmission de données ; et
ce circuit d'interface (10) comporte en outre une troisième résistance (R_{R2}), un deuxième commutateur (K_{R1}), une quatrième résistance (R_{R3}) et un troisième commutateur (K_{R2}),
une première extrémité de la troisième résistance (R_{R2}) étant couplée à l'extrémité d'alimentation électrique (Vcc) via le deuxième commutateur (K_{R1}) ;
une deuxième extrémité de la troisième résistance (R_{R2}), une première extrémité de la quatrième résistance (R_{R3}), et une extrémité de réception du récepteur (RX) étant toutes couplées à l'extrémité de transmission de données (J1) du circuit d'interface (10) ; et une deuxième extrémité de la quatrième résistance (R_{R3}) étant couplée à l'extrémité masse via le troisième commutateur (K_{R2}).

9. Dispositif électronique, ce dispositif électronique comprenant :
une interface physique ; et
le circuit d'interface (10) selon l'une quelconque des revendications 1 à 8,
ce circuit d'interface (10) étant couplé à une extrémité de transmission de données (J1) et à l'indicateur (Z) qui sont dans l'appareil de transmission de données via l'interface physique.

10. Dispositif électronique selon la revendication 9, dans lequel l'interface physique comporte une première extrémité de connexion (A111) et une deuxième extrémité de connexion (A112) ;
l'extrémité de transmission de données (J1) du circuit d'interface (10) étant couplée à la première extrémité de connexion (A111) ; et
l'extrémité d'indication d'interface (J2) du circuit d'interface (10) étant couplée à la deuxième extrémité de connexion (A112) .

11. Système comportant le circuit d'interface (10) selon la revendication 1 et un appareil de transmission de données, cet appareil de transmission de données étant couplé entre un premier dispositif (101) pas compris dans l'appareil de transmission de données et un deuxième dispositif (102) pas compris dans l'appareil de transmission de données et étant configuré de façon à transmettre des données entre le premier dispositif (101) et le deuxième dispositif (102), et l'appareil de transmission de données comportant :
un indicateur (Z), couplé au circuit d'interface (10) dans le deuxième dispositif (101) et configuré de façon à fournir une information d'indication au circuit d'interface (10), cette information d'indication indiquant un protocole d'interface de transmission de données du premier dispositif (102).

12. Appareil de transmission de données selon la revendication 11, cet appareil de transmission de données comportant :
une pluralité de câbles (C), cette pluralité de câbles (C) étant configurée de façon à coupler le premier dispositif (101) au deuxième dispositif (102), de telle sorte que les données sont transmises entre le premier dispositif (101) et le deuxième dispositif (102) via la pluralité de câbles (C).

13. Appareil de transmission de données selon la revendication 12, cet appareil de transmission de données comportant en outre une première fiche d'adaptation (C11) couplée au premier dispositif (101) et une deuxième fiche d'adaptation (C21) couplée au deuxième dispositif (102),
la première fiche d'adaptation (C11) comportant une première extrémité de transmission de données (C111) et une extrémité d'indication d'interface (C112), une première extrémité de chacun de la pluralité de câbles (C) étant couplée à la première extrémité de transmission de données (C111), et l'indicateur (Z) étant couplé à l'extrémité d'indication d'interface (C112), et
la deuxième fiche d'adaptation (C21) comportant une deuxième extrémité de transmission de données (C211), et une deuxième extrémité de chacun de la pluralité de câbles (C) étant couplée à la deuxième extrémité de transmission de données (C211).

14. Appareil de transmission de données selon l'une quelconque des revendications 11 à 13, dans lequel l'information d'indication est un signal analogique, l'indicateur (Z) comporte une cinquième résistance (R1), une extrémité de cette cinquième résistance (R1) est couplée à l'extrémité d'indication d'interface (C112) de la première fiche d'adaptation (C11), et l'autre extrémité de cette cinquième résistance (R1) est couplée à une extrémité masse.

15. Appareil de transmission de données selon l'une quelconque des revendications 11 à 13, dans lequel l'information d'indication est un signal numérique, et l'indicateur (Z) comporte un registre,
ce registre étant configuré de façon à stocker des données, et ces données indiquant un type de protocole d'une interface de transmission de données dans le deuxième dispositif (101).
